(19) Europäisches Patentamt
European Patent Office
Office européen des brevets

(11) **EP 2 210 119 B1**

(12) **FASCICULE DE BREVET EUROPEEN**

(45) Date de publication et mention de la délivrance du brevet:
**07.04.2021 Bulletin 2021/14**

(21) Numéro de dépôt: **08872049.5**

(22) Date de dépôt: **14.11.2008**

(51) Int Cl.:
*G01R 33/561* (2006.01)   *G01R 33/565* (2006.01)
*G01R 33/567* (2006.01)

(86) Numéro de dépôt international:
**PCT/FR2008/001601**

(87) Numéro de publication internationale:
**WO 2009/098371 (13.08.2009 Gazette 2009/33)**

(54) **PROCEDE DE RECONSTRUCTION D'UN SIGNAL A PARTIR DE MESURES EXPERIMENTALES PERTURBEES PAR LE MOUVEMENT**

VERFAHREN ZUM REKONSTRUIEREN EINES SIGNALS AUS EXPERIMENTELLEN MESSWERTEN MIT STÖRUNGEN DURCH BEWEGUNG

METHOD FOR RECONSTRUCTING A SIGNAL FROM EXPERIMENTAL MEASUREMENTS WITH INTERFERENCES CAUSED BY MOTION

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **14.11.2007 FR 0708003**

(43) Date de publication de la demande:
**28.07.2010 Bulletin 2010/30**

(73) Titulaire: **Université de Lorraine**
**54052 Nancy Cedex (FR)**

(72) Inventeurs:
• **ODILLE, Freddy**
**88460 Labaffe (FR)**
• **VUISSOZ, Pierre-André**
**54600 Villers-les -Nancy (FR)**
• **FELBLINGER, Jacques**
**54850 Mereville (FR)**

(74) Mandataire: **IPAZ**
**Parc Les Algorithmes, Bâtiment Platon**
**CS 70003 Saint-Aubin**
**91192 Gif-sur-Yvette Cedex (FR)**

(56) Documents cités:
**US-A- 4 701 706    US-A1- 2007 182 411**

• **ODILLE F ET AL: "Generalized reconstruction by inversion of coupled systems (GRICS) applied to free-breathing MRI" MAGNETIC RESONANCE IN MEDICINE, ACADEMIC PRESS, DULUTH, MN, US, 25 juin 2008 (2008-06-25), pages 146-157, XP002537561**
• **BAMMER R ET AL: "Augmented generalized SENSE reconstruction to correct for rigid body motion" MAGNETIC RESONANCE IN MEDICINE, vol. 57, 26 décembre 2006 (2006-12-26), pages 90-102, XP002482845 cité dans la demande**
• **BATCHELOR PG ET AL: "Matrix description of general motion correction applied to multishot images" MAGNETIC RESONANCE IN MEDICINE, vol. 54, 9 septembre 2005 (2005-09-09), pages 1273-1280, XP002482846**
• **HESS C P ET AL: "Maximum cross-entropy generalized series reconstruction" BIOMEDICAL IMAGING, 2002. 5TH IEEE EMBS INTERNATIONAL SUMMER SCHOOL ON JUNE 15-23, 2002, PISCATAWAY, NJ, USA,IEEE, 15 juin 2002 (2002-06-15), pages III_4_1-III_4_8, XP010659140 ISBN: 978-0-7803-7507-9**
• **DEMING R ET AL: "Computerized tomographic imaging of time-varying objects using mixture models" COMPUTATIONAL INTELLIGENCE FOR MEASUREMENT SYSTEMS AND APPLICATIONS, 2 005. CIMSA. 2005 IEEE INTERNATIONAL CONFERENCE ON MESSIAN, ITALY 20-22 JULY 2005, PISCATAWAY, NJ, USA,IEEE, 20 juillet 2005 (2005-07-20), pages 322-327, XP010845123 ISBN: 978-0-7803-9026-3**

- KNUTSSON H ET AL: "Motion artifact reduction in MRI through generalized DFT" BIOMEDICAL IMAGING: MACRO TO NANO, 2004. IEEE INTERNATIONAL SYMPOSIUM ON ARLINGTON,VA, USA APRIL 15-18, 2004, PISCATAWAY, NJ, USA,IEEE, 15 avril 2004 (2004-04-15), pages 896-899, XP010774077 ISBN: 978-0-7803-8389-0
- SODICKSON DANIEL K ET AL: "A generalized approach to parallel magnetic resonance imaging" MEDICAL PHYSICS, AIP, MELVILLE, NY, US, vol. 28, no. 8, 1 août 2001 (2001-08-01), pages 1629-1643, XP012011544 ISSN: 0094-2405 cité dans la demande
- PRUESSMANN K P ET AL: "Advances in sensitivity encoding with arbitrary k-space trajectories" MAGNETIC RESONANCE IN MEDICINE, ACADEMIC PRESS, DULUTH, MN, US, vol. 46, no. 4, 1 janvier 2001 (2001-01-01), pages 638-651, XP002288249 ISSN: 0740-3194 cité dans la demande
- ODILLE F ET AL: "Linear predictive modeling of patient motion using external sensors" PROCEEDINGS OF THE INTERNATIONAL SOCIETY FOR MAGNETIC RESONANCE IN MEDICINE, JOINT MEETING ISMRM-ESMRMB, BERLIN, GERMANY, 19-25 MAY 2008, 19 mai 2007 (2007-05-19), page 2524, XP002482847

**Description**

La présente invention concerne un procédé et un dispositif d'acquisition et de reconstruction d'un signal à partir de mesures expérimentales perturbées.

DOMAINE TECHNIQUE

La présente invention concerne les domaines de la Résonance Magnétique, notamment mais pas uniquement, l'Imagerie par Résonance Magnétique (IRM), la Spectroscopie par Résonance Magnétique Nucléaire (RMN) et l'Imagerie Médicale, dans cette dernière notamment mais pas uniquement la tomographie.

Elle concerne plus particulièrement, mais non exclusivement, l'acquisition, la reconstruction et l'obtention d'images en IRM.

Elle concerne plus particulièrement, mais non exclusivement, l'acquisition, la reconstruction et l'obtention d'images en IRM de sujets ou d'objets en mouvement pendant l'acquisition pour la correction des perturbations engendrées par ces dits mouvements.

L'invention peut également être mise en oeuvre pour d'autres modalités ou un signal est reconstruit à partir de mesures qui sont issues d'autres modalités d'imagerie médicale, par exemple en échographie ou en tomographie.

En plus de la correction de la perturbation par le mouvement, l'invention peut également être mise en œuvre pour la correction supplémentaire d'autres perturbations, notamment mais pas uniquement, l'établissement de cartes de sensibilité en IRM parallèle, la correction d'artéfacts dans les acquisitions de type « imagerie écho planaire » (EPI) en IRM, la correction des hétérogénéités dans les acquisitions IRM, ainsi que pour la correction d'autres artéfacts engendrés par une perturbation lors de mesures expérimentales.

ÉTAT DE LA TECHNIQUE ANTERIEURE

L'imagerie par résonance magnétique (IRM) est une technique radiologique non invasive basée sur le phénomène physique de résonance magnétique nucléaire (RMN). L'acquisition IRM d'images du corps humain consiste en une répétition d'une ou plusieurs expériences de RMN élémentaires, soit une succession d'excitations/acquisitions, chacune de ces expériences permettant de recueillir une partie de l'information image, codée par exemple en fréquence (acquisition dans l'espace de Fourier). Ce processus est séquentiel par nature, et donc relativement lent.

L'imagerie adaptative est l'ensemble des techniques permettant d'adapter le processus d'imagerie au patient, afin de tenir compte de la physiologie et du mouvement du patient ou de ses organes.

Dans le contexte de l'imagerie du corps humain, et en particulier en imagerie cardiaque et abdominale, le temps d'acquisition est souvent le facteur limitant. Les mouvements du patient en sont très souvent la cause principale. En cas de mouvement pendant l'acquisition, l'hypothèse implicite d'invariance de la distribution de protons imagée n'est plus vraie. Ceci engendre des dégradations de l'image. Ces dégradations sont appelées artéfacts, et peuvent rendre difficile, voire impossible, l'interprétation de l'image, et donc le diagnostic. Les mouvements du patient peuvent être de natures diverses : mouvements respiratoires, battement cardiaque, pulsations des vaisseaux. Outre la physiologie, des mouvements fortuits peuvent survenir, tels que des déplacements de la tête ou des mouvements résiduels lors d'apnées imparfaites. Enfin certains patients ne sont pas en mesure de tenir les apnées demandées (difficultés respiratoires), et d'autres peuvent être non-coopératifs (enfants).

La nécessité d'obtenir une résolution suffisante implique de construire une image à partir de plusieurs acquisitions, le nombre d'acquisitions dépendant directement de la résolution nécessaire. Chaque acquisition représente une partie de l'information image à reconstituer. Dans le cas de mouvements physiologiques lents au regard de la durée nécessaire à chacune de ces acquisitions élémentaires, c'est la combinaison des différentes acquisitions qui se fait de façon inconsistante. Ces perturbations sont alors appelées inter-acquisitions, et engendrent des artéfacts de type flou ou « fantômes » dans l'image reconstruite.

On connaît dans l'état de la technique des solutions s'appuyant sur les données issues de capteurs externes, tels que des ceintures respiratoires ou l'électrocardiogramme (ECG), afin d'introduire des informations de mouvements a priori dans les processus d'acquisition et de reconstruction IRM. Ces capteurs fournissent en effet des informations précieuses, disponibles pendant toute la durée de l'examen IRM, et sont déjà utilisées en pratique clinique pour le monitorage du patient (rythme cardiaque, suivi des apnées...) et également pour la synchronisation cardiaque (détection des ondes R de l'ECG).

Une première solution pour parer à l'apparition d'artéfacts dans une image IRM lors de la reconstruction de données corrompues par le mouvement consiste simplement à supprimer les données corrompues par le mouvement. Le jeu de données ainsi sous-échantillonné peut être reconstruit à l'aide de l'imagerie parallèle. Cette méthode n'est applicable que lorsque ces données corrompues sont en petit nombre.

Une deuxième solution consiste à vérifier la qualité des données lors de l'acquisition par exemple par l'utilisation d'écho navigateurs, et à répéter l'acquisition jusqu'à obtention d'un ensemble de données correctes. Cette méthode allonge de manière importante le processus d'acquisition.

Une troisième solution consiste, plutôt que de rejeter les données corrompues, à les corriger. L'état de la technique connaît à ce titre plusieurs procédés de reconstruction généralisée, dans lesquels la chaîne d'encodage spatial est modélisée par un ensemble d'opérateurs linéaires. La formulation dans [Batchelor et al. , 2005, « Matrix description of general motion correction applied to multishot images », Magn Reson Med, 54(5), 1273-1280] décrit une chaîne d'encodage spatial comprenant des mouvements arbitraires dans le champ de vue au cours de l'acquisition. La formulation dans [Pruessmann et al., 2001, « Advances in Sensitivity Encoding With Arbitrary k-Space Trajectories »] décrit une chaîne d'encodage spatial comprenant l'acquisition multi-antennes (la théorie de l'imagerie parallèle). Ces deux formulations peuvent être combinées dans un processus d'acquisition avec mouvement, qui s'écrit alors sous la forme d'une équation linéaire à inverser. L'inversion est théoriquement possible à condition que le signal IRM soit conservé dans le champ de vue au cours de l'acquisition. La réalisation pratique de la reconstruction généralisée nécessite la connaissance a priori du mouvement.

La solution décrite dans le brevet US 6,341,179 visant un procédé de reconstruction pour la réduction d'artéfacts sur des images physiologiques. La technique décrite est totalement automatique, et ne nécessite pas d'information autre que le jeu de données brutes. Le mouvement se produisant pendant l'acquisition est décrit par un petit nombre de paramètres (translations, rotations... à chaque temps d'acquisition). L'invention consiste ensuite à rechercher ces paramètres en optimisant une fonction de coût quantifiant la qualité de l'image reconstruite. L'entropie de Shannon est proposée pour cela, puisque la présence d'artéfacts augmente la dispersion du signal, et donc l'entropie de l'image.

Le principal inconvénient de cette solution réside dans le nombre de paramètres qu'il convient de choisir pour décrire le mouvement. Les résultats sont démontrés en imagerie neurologique uniquement, avec correction de mouvements rigides, donc non complexes, de la tête. Une description du mouvement plus fine que de simples rotations et translations nécessiterait un nombre très grand de paramètres. Le choix d'un critère comme l'entropie conduit à la résolution d'un problème non-linéaire difficile à optimiser, en particulier dans un espace de dimension élevée.

Il a également été proposé dans le brevet US 7,030,609 un procédé de reconstruction s'appuyant sur un schéma d'acquisition particulier de l'espace K. L'espace K est un outil de représentation mathématique bien connu en IRM. Il correspond à l'espace réciproque de l'espace image, de type espace de Fourier, dans lequel les données expérimentales servant à la reconstruction de l'image sont recueillies. Selon le brevet US 7,030,609, l'acquisition se fait selon un rectangle de données passant par le centre de l'espace K, appelé une pale, auquel on applique une rotation au cours du temps. Dans cette configuration, les données centrales de l'espace K sont acquises à chaque pale. Ceci permet de reconstruire une image basse résolution correspondant à chaque temps d'acquisition. Il est supposé que le mouvement est négligeable pendant l'acquisition d'une pale. L'invention propose de rechercher des paramètres de translations et rotations permettant de recaler les images basse résolution ainsi constituées. Les paramètres trouvés sont ensuite utilisés pour corriger l'ensemble du jeu de données brutes. Ceci est possible car les transformations affines (telles que les translations et rotations globales), se produisant dans le domaine image, équivalent à des transformations affines dans le domaine spectral (dans l'espace K). La technique est donc intrinsèquement limitée aux transformations affines.

Cette solution présente l'inconvénient de ne pas permettre une liberté de rotation du plan de coupe, du fait de la rotation des directions de fréquence et de phase au cours de la séquence. Le champ de vue représentant la bande passante de l'acquisition de l'espace K, un signal à l'extérieur du champ de vue sera donc en dehors de la bande passante d'acquisition. Le théorème de Shannon est alors invalidé, et l'image sera repliée.

La publication [Batchelor et al. , 2005, « Matrix description of general motion correction applied to multishot images », Magn Reson Med, 54(5), 1273-1280] divulgue un procédé de reconstruction dans le cas d'un mouvement « arbitraire ». En supposant que les champs de déplacements sont connus, il est possible de réécrire le problème d'acquisition IRM avec mouvement à l'aide d'un formalisme matriciel. Dans cette formulation discrète, tous les opérateurs intervenant sont linéaires. L'objet initial subit des déformations qui peuvent être modélisées, à un instant d'acquisition, par un opérateur de transformation spatiale. Puis l'objet est encodé spatialement (à l'aide du système de gradients), de façon à réaliser l'acquisition dans l'espace de Fourier. Une partie seulement des données est acquise à chaque acquisition, ce qui peut être représenté par un opérateur de trajectoire de parcours de l'espace K.

Le problème majeur d'une telle solution est qu'elle nécessite la connaissance a priori des matrices de transformation spatiale, c'est-à-dire du mouvement.

Enfin la publication [ Bammer et al., 2007, « Augmented Generalized SENSE Reconstruction to Correct for Rigid Body Motion », Magn. Reson. Med., 57(1), 90-102] visant un procédé de reconstruction reformulé sous un autre angle. Comme évoqué, les transformations affines sont changées en des transformations affines au cours d'une transformée de Fourier. Si l'on suppose que l'objet imagé subit de telles transformations, et que la trajectoire d'acquisition dans l'espace k est fixée, alors il est équivalent de considérer que c'est l'objet qui est fixe, et que c'est la trajectoire d'acquisition qui est déformée.

L'inconvénient d'une telle solution est que cette propriété n'est vraie que pour des transformations affines, donc la méthode est limitée à des transformations affines.

On connaît également les documents suivants, qui n'apportent toutefois pas non plus de solutions totalement satisfaisantes à la problématique de la reconstruction d'images IRM à partir de données corrompues par le mouvement :

- le document US 2007/0182411 A1 de Bammer et al. qui décrit un algorithme de correction des erreurs de phases en IRM dues au mouvement basé sur le gradient conjugué ;
- le document US 4,701,706 de Haacke et al., qui décrit un algorithme de reconstruction généralisé visant à corriger les erreurs d'échantillonnage en IRM dues aux mouvements et à d'autres sources de perturbations ;
- le document « Maximum Cross-Entropy Generalized Series reconstruction » de Hess et al, international Journal of Imaging System and Technology, 10:258-265, 1999, qui décrit un algorithme permettant d'améliorer la reconstruction d'images à partir d'ensembles de données dans l'espace de Fourier limitées ;
- le document « Computerized Tomographic Imaging of Time-varying Objects using Mixture models » de Deming et al., IEEE conférence CIMSA 2005, pp 322-327, 2005 qui décrit une méthode de reconstruction d'images de tomographie (CT) d'objets variant dans le temps ;
- le document « Motion artifact réduction in MRI through generalized DFT » de Knutsson H et al, IEEE International Symposium on Biomedical Imaging: Macro to Nano, pp 896-899, 2004, qui décrit une méthode permettant de réduite les artéfacts causés par les mouvements des patients tels que la respiration en imagerie IRM.

Ainsi les solutions proposées dans l'état de la technique sont limitées en nombre de données corrompues par le mouvement, en type de transformations applicables, ainsi qu'en nombre de degrés de liberté, rendant alors ce type de procédé inapplicable pour des mouvements complexes (par exemple non affines). De plus, la résolution est limitée par la nécessité d'une connaissance a priori du mouvement.

## OBJET DE L'INVENTION

Le but de la présente invention est de remédier aux inconvénients de l'état de la technique antérieure, en proposant un moyen de reconstruire un signal, par exemple une image, et de déterminer un modèle de la chaîne d'acquisition, par exemple du sujet dans le système d'IRM, incluant des perturbations de l'acquisition, telles que des mouvements physiologiques, directement à partir des données expérimentales corrompues.

En présence de sources de perturbation du problème de reconstruction d'un signal à partir de données expérimentales, par exemple en présence de mouvements physiologiques élastiques, l'invention permet de réduire l'effet de ces perturbations sur la reconstruction du signal. Pour ce faire, l'invention propose un modèle des perturbations, par exemple un modèle paramétrique décrivant les mouvements physiologiques élastiques à partir de données expérimentales issues de capteurs de mouvements, construit afin d'inclure les perturbations dans le problème de reconstruction du signal. Le modèle paramétrique décrivant les perturbations est alors couplé selon l'invention à un modèle paramétrique simulant le signal sans perturbation à reconstruire. Il s'agit de deux modèles que l'invention se propose d'optimiser de manière couplée.

À cet effet, la présente invention propose un procédé tel que défini dans la revendication indépendante 1. Des modes de réalisation avantageux sont définis dans les revendications dépendant de la revendication 1.

## BREVE DESCRIPTION DES DESSINS

L'invention sera mieux comprise à la lecture de la description détaillée d'un exemple non limitatif de réalisation, accompagné de figures représentant respectivement :

- la figure 1, un procédé de reconstruction généralisée par inversion de système couplé (GRICS) avec un modèle de simulation et un modèle de perturbation couplés, conforme à la présente invention,

- la figure 2, un procédé de reconstruction généralisée par inversion de système couplé avec un modèle de simulation et un modèle de perturbation couplés, utilisant une fonction de coût,

- la figure 3, un modèle de simulation d'une chaîne d'acquisition détaillé, conforme à la présente invention,

- la figure 4, un procédé de reconstruction généralisée par inversion de systèmes couplés avec un modèle de simulation et un modèle de perturbation couplés utilisant une optimisation par minimisation du résidu et une préparation de la reconstruction,

- la figure 5, un procédé de reconstruction généralisée par inversion de systèmes couplés multi-modèles de perturbation, et multi-résolutions,

- la figure 6, un procédé de reconstruction généralisée par inversion de systèmes couplés multi-modèles et dynamique, et

- la figure 7, un procédé de reconstruction généralisée par inversion de systèmes couplés itératif multi-résolutions avec modèle unique,

<u>EXPOSE DETAILLE DE MODES DE REALISATION PARTICULIERS</u>

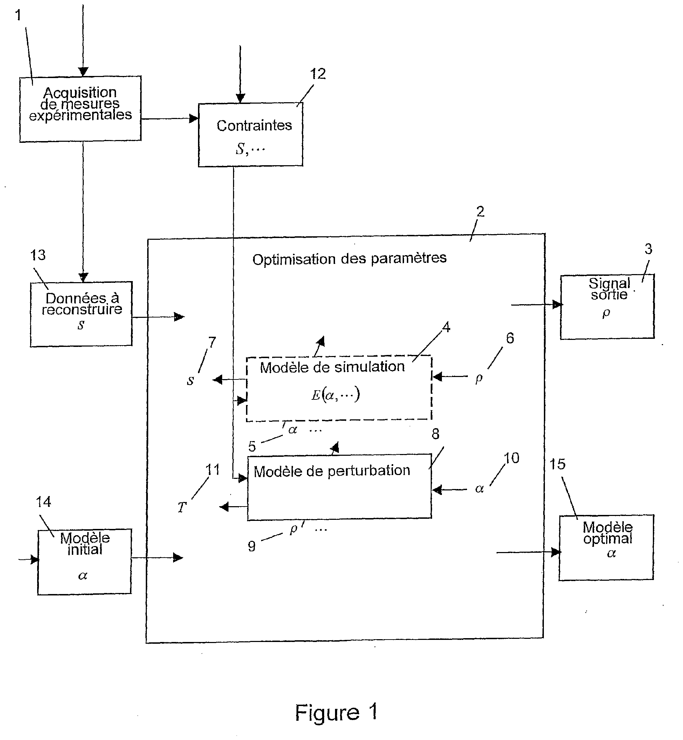

La figure 1 représente un procédé de reconstruction généralisée par inversion de systèmes couplés (GRICS) avec un modèle de simulation et un modèle de perturbation couplés, conforme à la présente invention.

Un procédé d'acquisition de mesures expérimentales perturbées et de reconstruction d'un signal ponctuel, mono- ou multidimensionnelle pouvant varier pendant l'acquisition des mesures expérimentales, conforme à la présente invention, peut être illustré par un procédé d'acquisition IRM parallèle (1) perturbée par un mouvement du sujet imagé et la reconstruction (2) d'une pile d'images $\rho$ (3) illustré en figure 1.

Il est entendu que cette illustration est un mode de réalisation particulier de l'invention, et que tout autre type de reconstruction généralisée par inversion de systèmes couplés (GRICS) serait possible à condition que cet autre type de reconstruction entre dans le cadre tel que défini dans les revendications suivantes.

Ce procédé permet en outre de s'affranchir de l'étape de calibration initiale du modèle décrivant les mouvements physiologiques du patient.

Ce procédé est aussi illustré par une acquisition de spectroscopie par RMN de type CSI (chemical shift imaging) ou par une acquisition tomographique tel que scanner ou PET, ces acquisitions étant perturbées par un mouvement.

Ce procédé utilise un modèle de simulation (4) de la chaîne d'acquisition IRM perturbée par le mouvement et dépendant des paramètres $\alpha$ (5) du modèle de perturbation par le mouvement. Ce modèle de simulation prend pour entrée la pile d'images $\rho$ (6) et fournit en sortie des données expérimentales simulées s (7). Ce procédé utilise un modèle de perturbation par le mouvement (8) dépendant des paramètres du modèle de simulation, l'image $\rho$ (9). Ce modèle de perturbation par le mouvement prend pour entrées les paramètres $\alpha$ (10) et fournit en sortie un opérateur de transformation spatiale $T$ (11). Des informations $S$ dérivées des mesures expérimentales et/ou des données expérimentales corrélées avec la cause du mouvement, comme par exemple des écho-navigateurs, des images partielles IRM ou des données issues de capteurs physiologiques, comme le signal d'une ceinture respiratoire ou la dérivée de ce signal, sont utilisées comme contraintes (12) dans les modèles de simulation (4) et de perturbation (5).

L'optimisation des paramètres $\alpha$ et $\rho$ est initialisée à l'aide des mesures expérimentales perturbée s (13) de paramètres initiaux $\alpha$ (14), qui sont soit issus de résultats antérieurs soit initialisés à une valeur constante qui peut être nulle. L'optimisation fournit en sortie l'image $\rho$ (3) et des paramètres optimaux $\alpha$ (15) du modèle de perturbation par le mouvement.

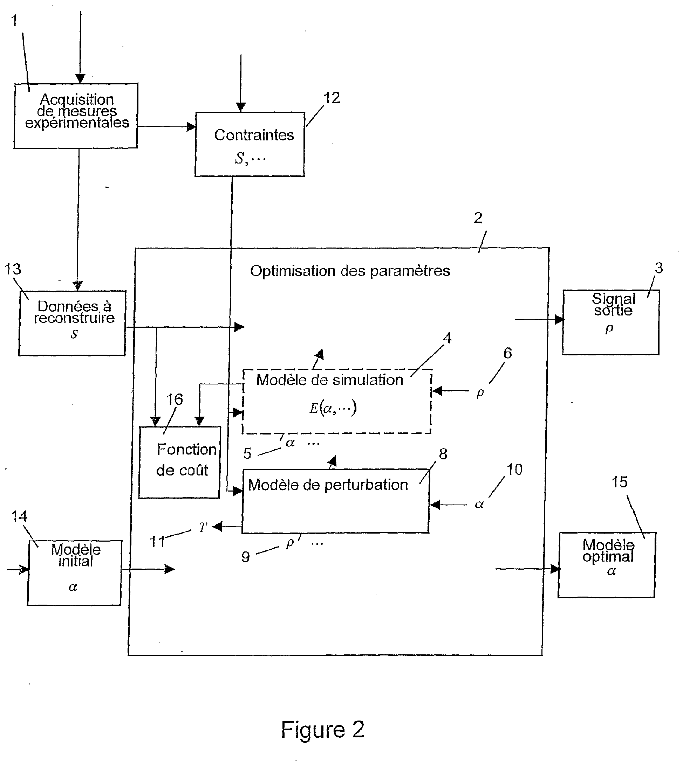

La figure 2, représente un procédé de reconstruction généralisée par inversion de systèmes couplés avec un modèle de simulation et un modèle de perturbation couplés, utilisant une fonction de coût, conforme à la présente invention.

Un procédé de reconstruction généralisée par inversion de systèmes couplés avec un modèle de simulation et un modèle de perturbation couplés, conforme à la présente invention peut être illustré par le procédé d'acquisition IRM parallèle (1) perturbée par un mouvement du sujet imagé et la reconstruction (2) d'une image $\rho$ déjà décrit ci-dessus dans les points (1) à (15). L'optimisation (2) inclut une fonction de coût (16) qui est soit une fonction qualifiant la qualité du signal telle que l'entropie de l'image, soit une fonction quantifiant l'adéquation entre les mesures expérimentales perturbées s (13) et les données expérimentales simulées s (7), telle que la différence entre ces deux termes.

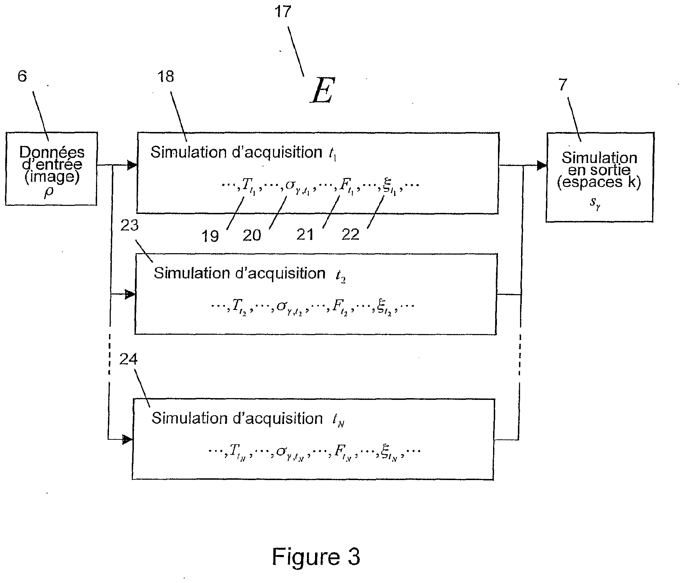

La figure 3 représente un modèle de simulation d'une chaîne d'acquisition (4) détaillé, conforme à la présente invention.

Le présent exemple concerne des images IRM en trois dimensions.

Ce procédé utilise un modèle de simulation de la chaîne d'acquisition IRM perturbée par le mouvement, illustré en figure 3, qui reprend les éléments (4), (6) et (7) décrits ci-dessus en explicitant la partie (4). Le modèle de simulation de la chaîne d'acquisition est réalisé sous la forme d'un opérateur linéaire $E$ (17) qui lie l'image $\rho$ (6) de dimension $N_x \times N_y \times N_z$ (nombres de voxels dans les 3 dimensions spatiales) aux données expérimentales simulées, de dimension $N_x \times N_y \times N_z \times N_\gamma \times N_R \times N_{NEX}$ ($N_\gamma$ nombre d'antennes, $N_R$ facteur de réduction d'IRM parallèle, $N_{NEX}$ nombre d'excitations de l'acquisition expérimentale). Les tailles typiques que l'on peut attendre pour les dimensions de l'opérateur $E$ sont $N_x \times N_y \times N_z$ = 256×256×32, $N_\gamma$ =8, $N_R$ =1 et $N_{NEX}$ =4.

L'opérateur $E$ est décomposé en un ou plusieurs sous-éléments (18), (23) à (24) qui simulent chacun l'acquisition IRM dans un groupe de positions physiologiques suffisamment proches pour ne pas perturber l'acquisition IRM. Typiquement le nombre de sous-éléments utilisés pour la réalisation du procédé illustrant l'invention est de 8. Les sous-éléments sont indexés par un indice $t_i$, qui représente le temps fictif d'acquisition d'un groupe de positions physiologiques suffisamment proches.

Les sous-éléments de l'opérateur $E$ comprennent :

- un opérateur de transformation spatiale $T_{t_i}$ (19) à un index $t_i$, opérateur d'interpolation qui est représenté par une matrice creuse de dimension $N_x N_y N_z \times N_x N_y N_z$ représentant le déplacement de $t_0$ à $t_i$. Le nombre d'éléments non-nuls de l'opérateur $T_{t_i}$ dépend de la base d'interpolation choisie (linéaire, cubique, sinc avec fenêtre de Kaiser-Bessel...). L'opérateur $T_{t_i}$ est choisi comme une transformation spatiale arbitraire (permettant la prise en compte de déformations localement libres), la restriction à une transformation affine est aussi possible dans une autre réalisation.

- un opérateur de pondération en sensibilité d'antenne $\sigma_\gamma$ (20) pour l'antenne $\gamma$, matrice diagonale de dimension $N_x N_y N_z \times N_x N_y N_z$,

- un opérateur de transformée de Fourier $F$ (21) en trois dimensions, de taille $N_x N_y N_z \times N_x N_y N_z$ ; selon un mode de réalisation particulier, l'opérateur (21) est un opérateur projectif pour créer les sinogrammes nécessaires à la simulation de l'acquisition tomographique par rayons X, TEP ou SPECT par exemple)

- et un opérateur d'échantillonnage $\xi_{t_i}$ (22) à un index $t_i$, une matrice creuse de dimension $N_{k\text{-}po\,\text{int}\,del'acquisition\,t_i} \times N_x N_y N_z$ qui prend des valeurs 0 ou 1 pour un échantillonnage cartésien. Dans une autre réalisation, l'échantillonnage peut être choisi comme non cartésien, l'opérateur d'échantillonnage sera alors l'inverse de l'opérateur de rééchantillonage sur grille cartésienne.

Le modèle de simulation (4) s'écrit alors de la façon suivante :

$$s = E\rho \qquad \text{(Eq. 1)}$$

L'opérateur s'écrit alors en empilant les acquisitions des différentes antennes de la façon suivante :

$$E = \begin{bmatrix} \xi_{t_1} F \sigma_1 T_{t_1} \\ \vdots \\ \xi_{t_N} F \sigma_1 T_{t_N} \\ \hline \vdots \\ \hline \xi_{t_1} F \sigma_{N_\gamma} T_{t_1} \\ \vdots \\ \xi_{t_N} F \sigma_{N_\gamma} T_{t_N} \end{bmatrix}, \qquad \text{(Eq. 2)}$$

L'implémentation de l'opérateur de Fourier est réalisée par transformée de Fourier rapide discrète en utilisant l'algorithme « Fastest Fourier Transform in the West » FFTW.

L'optimisation du signal $\rho$ est réalisée par la résolution du problème inverse de l'équation (Eq. 1), plus particulièrement en utilisant la formulation du problème à symétrie hermitienne qui s'écrit de la façon suivante :

$$E^H s = E^H E\rho, \quad \text{(Eq. 3)}$$

avec

$$E^H E = \sum_{n=1}^{N} T_{t_n}^{H} \left( \sum_{\gamma=1}^{N_\gamma} \sigma_\gamma^H F^H \xi_{t_n}^H \xi_{t_n} F \sigma_\gamma \right) T_{t_n}.$$

$$(\text{Eq. } 4).$$

L'équation (Eq. 3) est résolue à l'aide d'un algorithme itératif qui ne nécessite pas la connaissance explicite de l'opérateur $E^H E$ tel que la méthode du gradient conjugué ou la méthode du résidu minimal généralisé (GMRES). De tels algorithmes ne nécessitent que la connaissance de la fonction $x\alpha\ E^H Ex$ qui peut être calculée en appliquant les différents opérateurs dans la somme de l'équation (Eq. 4) en cascade. Ceci permet de limiter la demande en RAM dans l'implémentation et permet l'emploi de l'algorithme de transformée de Fourier rapide. Le conditionnement de l'opérateur $E^H E$ peut être augmenté en augmentant le nombre d'acquisitions indépendantes $N_{NEX}$. Une régularisation de Tikhonov est employée pour la résolution du problème inverse, l'opérateur $E^H E$ étant remplacé par $E^H E + \lambda Id$, $Id$ étant la matrice identité. Une valeur typique pour $\lambda$ est $\lambda$=0.01.

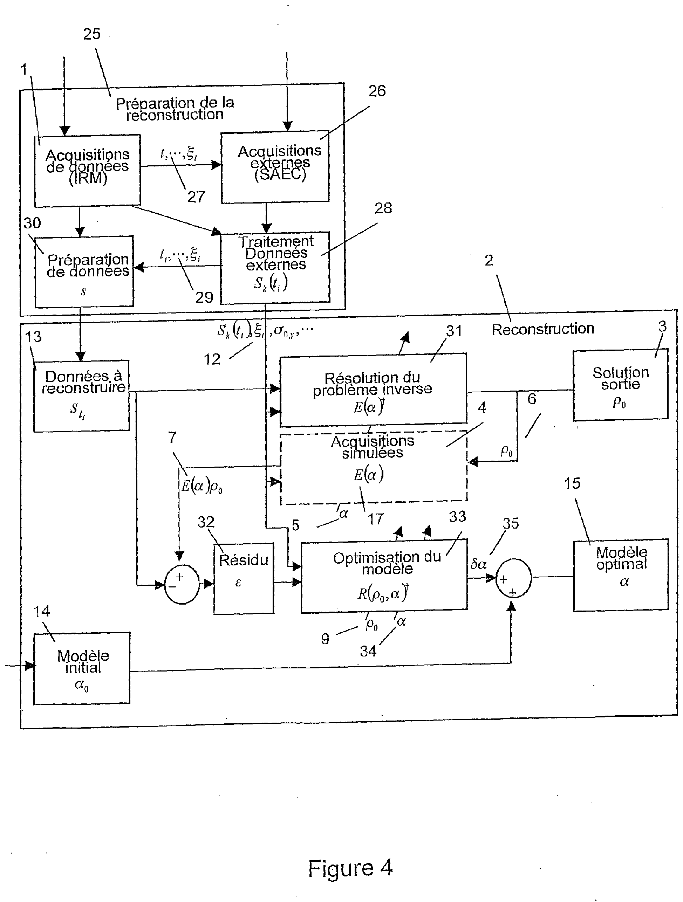

La figure 4, représente un procédé de reconstruction généralisée par inversion de systèmes couplés avec un modèle de simulation et un modèle de perturbation couplés utilisant une optimisation par minimisation du résidu et une préparation de la reconstruction, conforme à la présente invention.

Un procédé de reconstruction généralisée par inversion de systèmes couplés illustré dans la figure 4, reprend les éléments exposés ci-dessus, en particulier les éléments (1) à (5), (7), (9), (12) à (15) et (17).

Le procédé comprend une partie d'acquisition et de préparation de la reconstruction (25). Pour réaliser cette préparation, l'acquisition comprend un dispositif permettant l'acquisition de mesures externes (26), dénommé « Analyseur de Signaux et Contrôleur d'Evènements » (SAEC) permettant d'acquérir des signaux physiologiques, tels que la variation de pression de plusieurs ceintures pneumatiques et tels que plusieurs dérivations d'ECG. Le SAEC enregistre aussi les fenêtres d'acquisition IRM et la variation des gradients de champs magnétique des séquences IRM, ce qui permet de mettre en correspondance les événements relatifs à l'acquisition IRM (27) (en particulier les instants de mesures et l'ordre d'acquisition de données de l'espace K) avec les acquisitions physiologiques.

Le SAEC (Contrôler d'Evénements et Analyseur de Signaux) est une plate-forme d'acquisition et de traitement en temps réel des données physiologiques.

Le procédé comprend un module de traitement des données externe (28) qui reçoit tous les enregistrements du SAEC. Selon une autre réalisation le module de traitement des données externe reçoit les données dérivées d'écho-navigateurs IRM ou d'images partielles formées à partir d'une partie de l'acquisition IRM, qui sont corrélées aux mouvements physiologiques (respiration ou battement cardiaque). Le module de traitement des données externe opère un quantification des signaux des ceintures respiratoires et de leurs dérivées, soit les $S_k(t_i)$. Cette quantification permet de regrouper les acquisitions IRM en groupes de points de l'espace K ayant les mêmes acquisitions physiologiques quantifiées, groupes décrits par les opérateurs $\xi_{t_i}$. L'indice de quantification est $t_i$. Ces valeurs sont transmises (29) au module de préparation des données (30).

Le procédé comprend un module de préparation des données (30) qui reçoit les données expérimentales perturbées du système IRM (1). Il regroupe les données liées par un même indice de quantification $t_i$. Il effectue aussi les transformations de Fourier dans les directions indépendantes de la perturbation par le mouvement, diminuant d'autant la taille du problème. Il fournit en sortie les données expérimentales à reconstruire (13).

Les opérateurs de transformées spatiales $T_{t_i}$ sont déterminés à partir d'un modèle de perturbation par le mouvement. Ce modèle permet de réduire le nombre de paramètres décrivant le mouvement de manière significative, tout en autorisant des déformations spatiales libres localement. Il est tel que l'évolution temporelle de chaque voxel est exprimée comme une combinaison linéaire des signaux $S_k(t_i)$ corrélés avec le mouvement. De tels signaux d'entrée peuvent être des écho-navigateurs ou des capteurs externes, comme des ceintures respiratoires et des ECG, ou des signaux dérivés de ceux-ci. Le modèle de perturbation par le mouvement est décrit par un champ de déplacement $u(r,t)$ à la positon r =[x,y,z]$^T$ et au temps t, ce modèle peut décrire des mouvements élastiques par la combinaison linéaire suivante :

$$u(r,t) = \sum_{k=1}^{K} S_k(t).\alpha_k(r) \qquad (\text{Eq. } 5)$$

Les cartes de coefficients $\alpha_k(r) = [\alpha_{k,x}(r) \mid \alpha_{k,y}(r) \mid \alpha_{k,z}(r)]^T$ décrivent le modèle de perturbation. Une carte de coefficients est définie pour chaque signal et chaque dimension spatiale.

Le mouvement est ainsi représenté par une combinaison linéaire dont la variation temporelle dépend des signaux « extérieurs » corrélés avec la variation temporelle du mouvement, qui est multipliée par une matrice de coefficients a, pour chaque voxel de l'image et pour chaque direction de l'espace.

Il est entendu que cette modélisation linéaire est un mode de réalisation particulier de l'invention, et que tout autre type de modélisation est également possible.

De plus, d'autres perturbations supplémentaires à la perturbation par le mouvement peuvent être envisagées, telles qu'une modélisation des erreurs faites sur les cartes sensibilité d'antennes. Dans la réalisation présentée, on choisit de représenter les cartes de sensibilité par un modèle invariant dans le temps. Le modèle se réduit alors à un ensemble de cartes de sensibilité variant uniquement dans l'espace qui s'écrit sous la forme d'un opérateur matriciel diagonal : $\sigma_\gamma$ (de taille $N_x N_y N_z \times N_x N_y N_z$)

La résolution du problème inverse du modèle de simulation (31) dépend des paramètres du modèle de perturbation par le mouvement (5). Il est résolu par une méthode itérative de type GMRES.

L'image $\rho_0$ (6) issue de la résolution du problème inverse du modèle de simulation (31) est injectée dans le modèle de simulation (4) pour générer des données brutes simulées $E(\alpha)\rho_0$ (7)

Le résidu $\varepsilon$ est calculé (32) à partir de la différence entre les mesures expérimentales (13) et les résultats de la simulation (7), il est exprimé comme suit :

$$\varepsilon = s - E\rho_0 \quad \text{(Eq. 6)}$$

Le procédé comprend un opérateur de résidu $R$ dépendant des paramètres du modèle de simulation $\rho$ (9) et des paramètres du modèle de perturbation de mouvement $\alpha$ (34), qui associe une petite variation des paramètres du modèle de perturbation de mouvement $\delta\alpha$ (35) au résidu $\varepsilon$ (32). Cet opérateur est linéaire.

En effet en utilisant la conservation du signal IRM, on peut écrire :

$$\frac{d\rho}{dt} = 0 \Rightarrow \frac{\partial\rho}{\partial t} + \frac{\partial\rho}{\partial r} \cdot \frac{\partial r}{\partial t} \Rightarrow \frac{\partial\rho}{\partial t} = -\frac{\partial\rho}{\partial r} \cdot \frac{\partial r}{\partial t} = -\nabla_r\rho \cdot \frac{\partial r}{\partial t} \quad \text{(Eq. 7)}$$

Une petite erreur sur la description du mouvement $\delta u(r,t)$ a pour conséquence une erreur sur les données simulées.

L'expérience IRM s'écrit comme la production de données brutes à partir d'une image optimale $\rho_0$ sans perturbation (déplacement) :

$$s = E\rho_0 = \begin{bmatrix} \xi_{t_1} F\sigma_1 T_{t_1} \\ \vdots \\ \xi_{t_N} F\sigma_1 T_{t_N} \\ \hline \vdots \\ \hline \xi_{t_1} F\sigma_{N_y} T_{t_2} \\ \vdots \\ \xi_{t_N} F\sigma_{N_y} T_{t_N} \end{bmatrix} \rho_0 \cdot \qquad \text{(Eq. 8)}$$

L'expérience IRM s'écrit aussi comme la production de données brutes à partir d'un ensemble images perturbées (comprenant la transformation spatiale) $\rho_{t_i}$ :

$$s = \begin{bmatrix} \xi_{t_1} F\sigma_1 (T_{t_1}\rho_0) \\ \vdots \\ \xi_{t_N} F\sigma_1 (T_{t_N}\rho_0) \\ \hline \vdots \\ \hline \xi_{t_1} F\sigma_{N_y} (T_{t_1}\rho_0) \\ \vdots \\ \xi_{t_N} F\sigma_{N_y} (T_{t_N}\rho_0) \end{bmatrix} = \begin{bmatrix} \xi_{t_1} F\sigma_1 \rho_{t_1} \\ \vdots \\ \xi_{t_N} F\sigma_1 \rho_{t_N} \\ \hline \vdots \\ \hline \xi_{t_1} F\sigma_{N_y} \rho_{t_1} \\ \vdots \\ \xi_{t_N} F\sigma_{N_y} \rho_{t_N} \end{bmatrix} . \qquad \text{(Eq. 9)}$$

Une petite erreur sur la description du mouvement crée des images différentes $\rho_{t_i}$ que l'on peut introduire dans l'équation (Eq. 9) :

$$s = \begin{bmatrix} \xi_{t_1} F\sigma_1 \hat{\rho}_{t_1} \\ \vdots \\ \xi_{t_N} F\sigma_1 \hat{\rho}_{t_N} \\ \vdots \\ \xi_{t_1} F\sigma_{N_\gamma} \hat{\rho}_{t_1} \\ \vdots \\ \xi_{t_N} F\sigma_{N_\gamma} \hat{\rho}_{t_N} \end{bmatrix} + \begin{bmatrix} \xi_{t_1} F\sigma_1 (\rho_{t_1} - \hat{\rho}_{t_1}) \\ \vdots \\ \xi_{t_N} F\sigma_1 (\rho_{t_N} - \hat{\rho}_{t_N}) \\ \vdots \\ \xi_{t_1} F\sigma_{N_\gamma} (\rho_{t_1} - \hat{\rho}_{t_1}) \\ \vdots \\ \xi_{t_N} F\sigma_{N_\gamma} (\rho_{t_N} - \hat{\rho}_{t_N}) \end{bmatrix}, \quad \text{(Eq. 10)}$$

L'équation (Eq. 10) est interprétée comme la différence entre une simulation comprenant une erreur d'estimation de la perturbation $\hat{E}$ et la simulation optimale :

$$s = \hat{E}\rho_0 + \varepsilon. \quad \text{(Eq. 11)}$$

Moyennant une petite erreur faite sur la description du mouvement, et donc sur les champs de déplacement, on écrit la différence d'images de l'équation (Eq. 10) :

$$\rho_{t_n} - \hat{\rho}_{t_n} = \left(-\nabla\hat{\rho}_{t_n}\right)^T \cdot \delta u_{t_n} + \mathcal{O}\left(\left\|\delta u_{t_n}\right\|^2\right) \quad \text{(Eq. 11)}$$

Le résidu s'écrit alors :

$$\varepsilon \simeq \begin{bmatrix} \xi_{t_1} F\sigma_1 \left(-\nabla\hat{\rho}_{t_1}\right)^T \cdot \delta u_{t_1} \\ \vdots \\ \xi_{t_N} F\sigma_1 \left(-\nabla\hat{\rho}_{t_N}\right)^T \cdot \delta u_{t_N} \\ \vdots \\ \xi_{t_1} F\sigma_{N_\gamma} \left(-\nabla\hat{\rho}_{t_1}\right)^T \cdot \delta u_{t_t} \\ \vdots \\ \xi_{t_N} F\sigma_{N_\gamma} \left(-\nabla\hat{\rho}_{t_N}\right)^T \cdot \delta u_{t_N} \end{bmatrix}, \quad \text{(Eq. 12)}$$

En réintroduisant le modèle de perturbation de mouvement dans l'équation (Eq. 12) on écrit :

$$\varepsilon = \begin{bmatrix} \xi_{t_1} F \sigma_1 \left( -\nabla \hat{\rho}_{t_1} \right)^T \cdot \sum_{k=1}^{K} S_k(t_1) \delta \alpha_k \\ \vdots \\ \xi_{t_N} F \sigma_1 \left( -\nabla \hat{\rho}_{t_N} \right)^T \cdot \sum_{k=1}^{K} S_k(t_N) \delta \alpha_k \\ \vdots \\ \xi_{t_1} F \sigma_{N_\gamma} \left( -\nabla \hat{\rho}_{t_1} \right)^T \cdot \sum_{k=1}^{K} S_k(t_1) \delta \alpha_k \\ \vdots \\ \xi_{t_M} F \sigma_{N_\gamma} \left( -\nabla \hat{\rho}_{t_N} \right)^T \cdot \sum_{k=1}^{K} S_k(t_N) \delta \alpha_k \end{bmatrix} = R(\rho_0, \alpha)\, \delta \alpha. \qquad \text{(Eq 13)}$$

L'opérateur de résidu $R(\rho_0, \alpha)$ s'écrit alors en fonction des mêmes opérateurs compris dans l'opérateur de simulation $E(\alpha)$, auxquels s'ajoutent une composition du gradient spatial du signal actuel $(-\nabla \hat{\rho}_{t_1})^T$ et des informations corrélées au mouvement $S_k(t_n)$ :

$$\varepsilon = R(\rho_0, \alpha)\delta\alpha = \begin{bmatrix} \xi_{t_1} F_{\sigma_1} \left( -\nabla \hat{\rho}_{t_1} \right)^T \cdot \sum_{k=1}^{K} S_k(t_1).\delta\alpha_k \\ \cdot \\ \cdot \\ \cdot \\ \xi_{t_N} F_{\sigma_1} \left( -\nabla \hat{\rho}_{t_N} \right)^T \cdot \sum_{k=1}^{K} S_k(t_N).\delta\alpha_k \\ \overline{\cdot} \\ \cdot \\ \cdot \\ \xi_{t_1} F_{\sigma_{N_\gamma}} \left( -\nabla \hat{\rho}_{t_1} \right)^T \cdot \overline{\sum_{k=1}^{K} S_k(t_1).\delta\alpha_k} \\ \cdot \\ \cdot \\ \cdot \\ \xi_{t_N} F_{\sigma_{N_\gamma}} \left( -\nabla \hat{\rho}_{t_N} \right)^T \cdot \sum_{k=1}^{K} S_k(t_N).\delta\alpha_k \end{bmatrix} \qquad \text{(Eq. 14)}$$

L'équation (Eq. 14) présente une relation linéaire entre une petite variation des paramètres du modèle de perturbation de mouvement $\delta\alpha$ et le résidu $\varepsilon$.

L'optimisation des paramètres du modèle de perturbation $\alpha$ est réalisée par la résolution du problème inverse de l'opérateur de résidu (33), prenant pour entrée le résidu $\varepsilon$ et fournissant en sortie les erreurs faites sur les paramètres du modèle de perturbation $\delta\alpha$ (35). Une fois obtenues, ces erreurs $\delta\alpha$ sont utilisées pour actualiser les paramètres du modèle de perturbation par le mouvement. De même que pour le problème inverse (31), la résolution du problème inverse est effectuée en résolvant le problème à symétrie hermitienne équivalent en utilisant la méthode itérative GMRES, et une régularisation de type contrainte sur le carré de la norme du gradient spatial des paramètres du modèle de perturbation, additionnés des erreurs sur les paramètres du modèle de perturbation correspondant à la minimisation exprimée comme suit :

$$\delta\alpha^{(k)} = \min_{\delta\alpha} \left\{ \|R(\rho_0^{(k)}, \alpha^{(k)})\delta\alpha - \varepsilon\|^2 + \mu\|\nabla(\alpha^{(k)} + \delta\alpha)\|^2 \right\}$$

(Eq. 15)

Une valeur typique du paramètre de régularisation est $\mu = 0.1\|\varepsilon\|$

Ce procédé permet d'obtenir une solution image $\rho_0$ et un modèle optimal a, ces deux derniers étant obtenus par des étapes d'optimisation. Un tel procédé pourra être reproduit de manière itérative, comme cela sera vu ci-après.

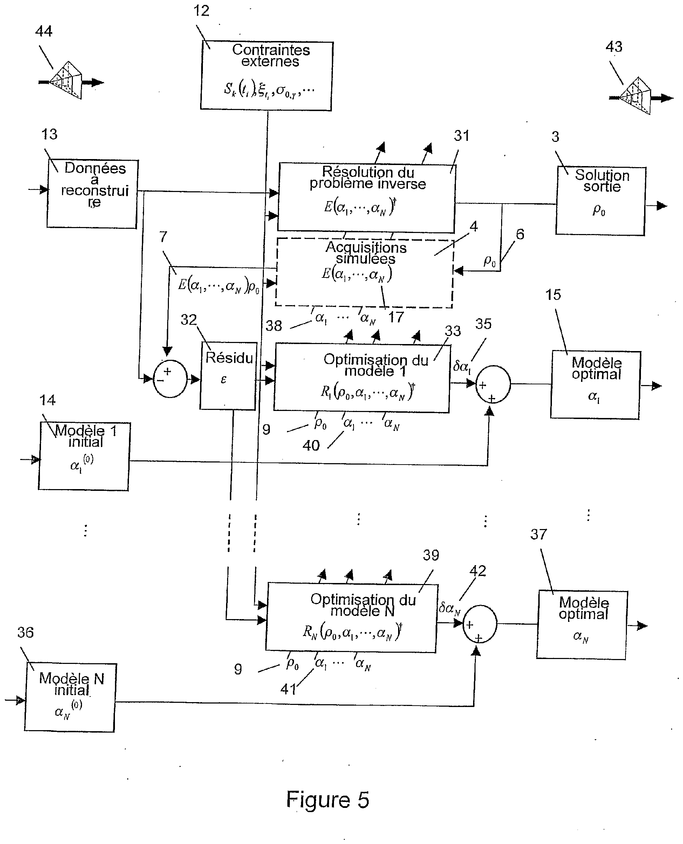

La figure 5 représente un procédé de reconstruction généralisée par inversion de systèmes couplés, multi-modèles de perturbation, et multi-résolutions, conforme à la présente invention.

Un procédé de reconstruction généralisée par inversion de systèmes couplés multi-modèles de perturbation, et multi-résolutions, conforme à la présente invention peut être illustré par le procédé de reconstruction d'une acquisition IRM parallèle perturbée par un mouvement du sujet imagé et par une erreur faite sur les cartes de sensibilité des antennes réceptrices, déjà décrit ci-dessus dans les points (1) à (35), où est introduit un second modèle de perturbation de sensibilité $\alpha_2 = \sigma_\gamma$

$$\alpha_2 \equiv \frac{1}{\gamma}$$

Le second modèle est initialisé (36), de manière typique on peut prendre $\quad$ ou encore des valeurs issues d'une calibration préalable.

Le processus de reconstruction fournit les paramètres optimisés du second modèle (37).

L'introduction d'un second modèle rend l'opérateur $E$ dépendant (38) des nouveaux paramètres $\alpha_2$.

De même pour l'opérateur de résidu $R_1$ lui aussi dépendant (40) des nouveaux paramètres $\alpha_2$.

Les systèmes couplés s'écrivent :

$$\begin{cases} s = E(\alpha)\rho_0 & \text{(erreur de la reconstruction généralisée)} \\ \varepsilon_1(\rho_0, \alpha, \sigma, \delta\alpha) = R_1(\rho_0, \alpha, \sigma)\,\delta\alpha & \text{(erreur sur les coefficients du modèle)} \\ \varepsilon_2(\rho_0, \alpha, \sigma, \delta\sigma) = R_2(\rho_0, \alpha, \sigma)\,\delta\sigma & \text{(erreur sur les cartes de sensibilité)} \end{cases}$$

(Eq. 16)

Avec l'opérateur de résidu du premier modèle $R_1$

$$\varepsilon_1 = \begin{bmatrix} \xi_{t_1} F\hat{\sigma}_1 \left(-\nabla\hat{\rho}_{t_1}\right)^T \cdot \sum_{k=1}^{K} S_k(t_1)\delta\alpha_k \\ \vdots \\ \xi_{t_N} F\hat{\sigma}_1 \left(-\nabla\hat{\rho}_{t_N}\right)^T \cdot \sum_{k=1}^{K} S_k(t_N)\delta\alpha_k \\ \hline \vdots \\ \hline \xi_{t_1} F\hat{\sigma}_{N_\gamma} \left(-\nabla\hat{\rho}_{t_1}\right)^T \cdot \sum_{k=1}^{K} S_k(t_1)\delta\alpha_k \\ \vdots \\ \xi_{t_N} F\hat{\sigma}_{N_\gamma} \left(-\nabla\hat{\rho}_{t_N}\right)^T \cdot \sum_{k=1}^{K} S_k(t_N)\delta\alpha_k \end{bmatrix} = R_1(\rho_0, \alpha, \sigma)\,\delta\alpha$$

$$\text{(Eq. 17)}$$

et l'opérateur de résidu du second modèle $R_2$

$$\varepsilon_2 = \begin{bmatrix} \xi_{t_1} F\mathrm{diag}\left(\hat{\rho}_{t_1}\right)\delta\sigma_1 \\ \vdots \\ \xi_{t_N} F\mathrm{diag}\left(\hat{\rho}_{t_N}\right)\delta\sigma_1 \\ \hline \vdots \\ \hline \xi_{t_1} F\mathrm{diag}\left(\hat{\rho}_{t_1}\right)\delta\sigma_{N_\gamma} \\ \vdots \\ \xi_{t_N} F\mathrm{diag}\left(\hat{\rho}_{t_N}\right)\delta\sigma_{N_\gamma} \end{bmatrix} = R_2(\rho_0, \alpha, \sigma)\,\delta\sigma$$

$$\text{(Eq. 18)}$$

L'opérateur de résidu $R_2$ dépend de $\alpha_1$ (41)

De la même manière que pour le premier modèle (33), l'optimisation du second modèle est réalisée par la résolution du problème inverse (39) de l'équation (Eq.18) en utilisant le modèle hermitien équivalent, l'algorithme GMRES et une régularisation correspondant à la minimisation :

$$\delta\sigma^{(k)} = \min_{\delta\sigma}\{\|\varepsilon - R\delta\sigma\|^2 + \mu\|\nabla(\sigma + \delta\sigma)\|^2\}.$$

$$\text{(Eq 19)}$$

L'optimisation (39) fournit en sortie une estimation des erreurs faites sur les paramètres du modèle de perturbation $\delta\alpha_2$ (42). Une fois obtenues, ces erreurs $\delta\alpha_2$ sont utilisées pour actualiser les paramètres du modèle de perturbation.

L'optimisation couplée du modèle de simulation et de deux modèles de perturbation est réalisée par une méthode de point fixe, c'est-à-dire que chaque modèle est optimisé séparément, tous les autres étant considérés fixés. Cette optimisation est réalisée de manière alternée sur le modèle de simulation puis sur un des deux modèles de perturbation, cette séquence d'optimisation étant répétée alternativement sur chacun des modèles.

L'optimisation des paramètres des modèles de simulation et de perturbations couplés est répétée selon une itération primaire (57) de l'optimisation des paramètres, régie par une condition d'arrêt (58), qui est bornée par un nombre fixé d'itérations, typiquement 8, jusqu'à ce que la norme euclidienne du résidu cesse de diminuer. Les paramètres optimaux sont ceux donnant le plus petit résidu lors de la condition d'arrêt.

L'optimisation des paramètres des modèles de simulation et de perturbations couplés est répétée selon une itération secondaire (59) multi-résolutions, établie sur la base d'un niveau de résolution de l'image (3).

A la fin de l'itération primaire, les paramètres (3),(15),(37) sont passés au prochain niveau de l'itération secondaire (43), en interpolant les cartes de coefficients au prochain niveau de résolution (interpolation linéaire).

Pour chaque niveau d'itération secondaire, les paramètres (14) et (36) sont initialisés en utilisant les valeurs de l'itération précédente (44) et en doublant la résolution de l'image. Typiquement la première itération est effectuée avec une résolution de 32.

Le niveau de résolution initial est choisi de sorte que le mouvement puisse être considéré comme petit à ce niveau de résolution. Ce niveau de résolution initial dépend de l'application considérée. Pour une image clinique 2D de résolution finale 256*256, le niveau de résolution initial est ainsi fixé à 32*32.

La condition d'arrêt de l'itération secondaire est un nombre d'itérations fixé correspondant à la résolution maximale de l'acquisition, typiquement 4 ou 5.

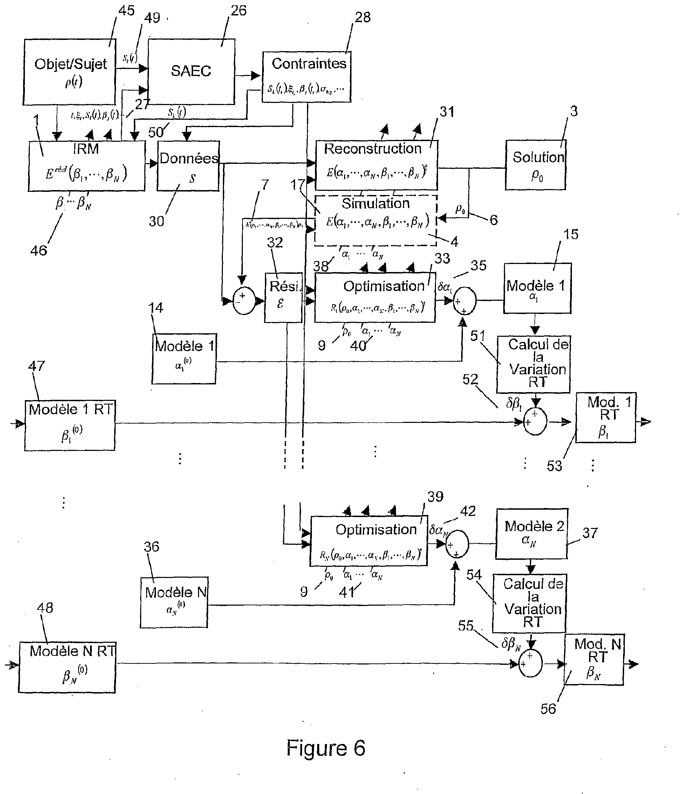

La figure 6 représente un procédé d'acquisition et de reconstruction généralisée par inversion de systèmes couplés, multi-modèles et adaptatif, conforme à la présente invention.

Un procédé d'acquisition et de reconstruction généralisée par inversion de systèmes couplés multi-modèles et adaptatif, conforme à la présente invention peut être illustré par le procédé d'acquisition et de reconstruction IRM parallèle, perturbée par un mouvement du sujet imagé et par une erreur faite sur les cartes de sensibilité des antennes réceptrices, déjà décrit ci-dessus dans les points (1) à (42), (57) et (58)

Le sujet (45) est placé dans un système IRM (1) dont, entre autres, la résolution de l'acquisition d'image IRM est ajustable (46).

Les paramètres d'acquisition ajustables $\beta_i$ sont déterminés par des modèles initiaux (47),(48). Typiquement, la résolution initiale est de 64.

Des paramètres physiologiques tels que des signaux issus de ceintures respiratoires et d'ECG sont acquis en temps réel pendant l'acquisition IRM (49).

Les informations dérivées de ces capteurs sont envoyées au système IRM en temps réel (50) et peuvent servir à asservir les modèles déterminant les paramètres d'acquisition ajustables $\beta_i$.

A partir des paramètres optimaux des modèles de perturbation (15) et (37) sont dérivés par un procédé (51) et (54), les valeurs (52) et (55) servant à actualiser les modèles des paramètres d'acquisition ajustables (53) et (56).

Pour la résolution de l'acquisition, la dimension de l'image dérivée de la dimension du modèle (15) est doublée en (53).

Les acquisitions sont répétées jusqu'à atteindre un nombre d'itérations prédéterminé correspondant à la résolution finale choisie, typiquement de 256.

Il est entendu que ce mode de mise en œuvre peut être combiné à celui décrit dans les figure 4,5 et 7 de sorte à y intégrer les itérations primaires et secondaires et les autres élément y figurant.

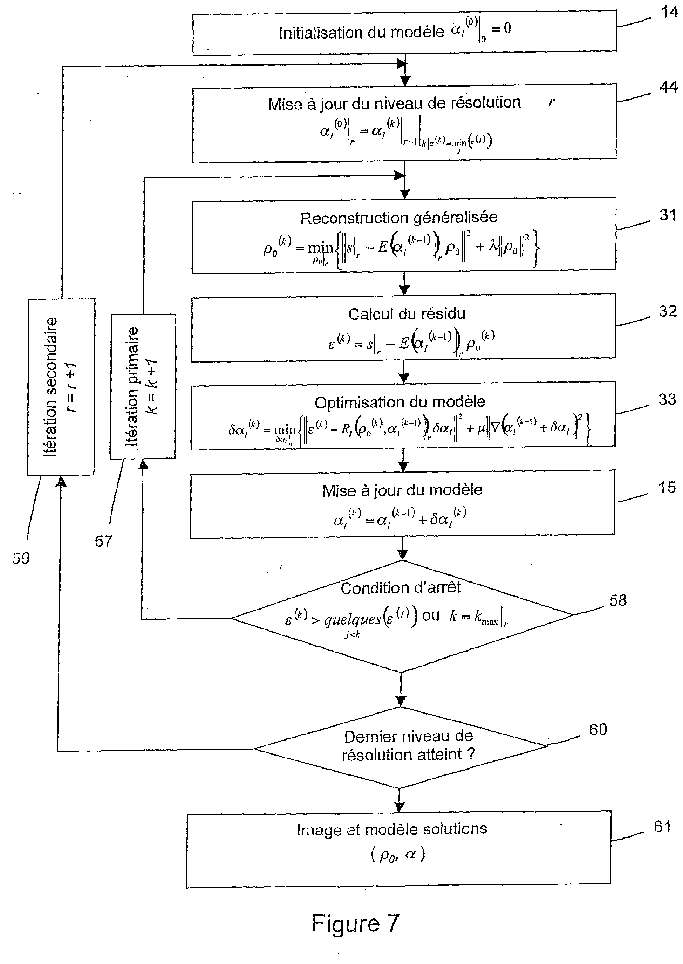

La figure 7 représente un procédé de reconstruction généralisée par inversion de systèmes couplés itératif multi-résolutions avec modèle unique, conforme à la présente invention.

Un procédé de reconstruction généralisée par inversion de systèmes couplés itératif multi-résolutions avec modèle unique, conforme à la présente invention, peut être illustré par le procédé de reconstruction d'une acquisition IRM parallèle perturbée par un mouvement du sujet imagé, déjà décrit ci-dessus dans les points (1) à (35).

L'optimisation des paramètres des modèles de simulation et de perturbations couplés est répétée selon une itération primaire (57) de l'optimisation des paramètres, régie par une condition d'arrêt (58), qui est bornée par un nombre fixe d'itérations, typiquement 8, jusqu'à ce que la norme euclidienne du résidu cesse de décroître. Les paramètres optimaux sont ceux donnant le plus petit résidu lors de la condition d'arrêt.

L'optimisation des paramètres des modèles de simulation et de perturbations couplés est répétée selon une itération secondaire (59) multi-résolutions, établie sur la base d'un niveau de résolution de l'image (3).

A la fin de l'itération primaire, les paramètres (3) et (15), sont passés au prochain niveau de l'itération secondaire.

Pour chaque niveau d'itération secondaire, les paramètres sont initialisés en utilisant les valeurs de l'itération précédente (44) et en doublant la résolution de l'image. Typiquement la première itération est effectuée avec une résolution de 32.

La condition d'arrêt de l'itération secondaire est un nombre d'itérations fixé (60) correspondant à la résolution maximale de l'acquisition, typiquement 4 ou 5.

Le procédé retourne comme résultat une pile d'images et un jeu de paramètres optimal (61).

Selon un autre mode particulier de réalisation, le procédé fournit le modèle obtenu à l'avant-dernier niveau de résolution. Cela permet d'économiser la dernière étape d'optimisation du modèle, qui est la plus coûteuse en temps de traitement.

Ce procédé permet en outre de s'affranchir de l'étape de calibration initiale du modèle décrivant les mouvements physiologiques du patient.

Dans les modes de mise en œuvre ci-dessus, le modèle linéaire est initialisé (14) en prenant tous les coefficients de la matrice $\alpha$ égaux à zéro, ce qui correspond à $\alpha^{(0)} \equiv 0$.

De manière avantageuse, le modèle est calibré initialement à niveau de résolution initial, préalablement aux itérations (57,59), afin de donner une première prédiction du mouvement.

Elle est réalisée à partir d'une séquence IRM dynamique rapide, à basse résolution spatiale, mais à résolution temporelle élevée et fait apparaître la dynamique du mouvement. Elle met également en œuvre un algorithme de détection de mouvements ou de recalage d'images.

Le modèle est calibré spécifiquement pour chaque patient, et pour une configuration de capteurs donnée. Une fois la calibration effectuée, les paramètres $\theta(t)$ décrivant les mouvements réels du patient sont prédits par le produit de $\alpha$ avec les nouvelles valeurs fournies par les signaux d'entrée.

Plusieurs types de signaux peuvent être utilisés comme entrées du modèle : les signaux issus de données IRM et les signaux provenant de capteurs externes. Les signaux provenant de l'IRM (écho-navigateurs, lignes centrales de l'espace K...) permettent de donner directement une information image et de suivre des mouvements en surface ou des mouvements internes d'organes. Les données provenant de capteurs externes permettent de prédire les mouvements indépendamment de l'acquisition IRM.

Les informations partielles, extraites des données de capteurs externes ou des données IRM, constituent les signaux d'entrée du modèle. Pour d'autres applications, par exemple le suivi d'un cycle cardiaque, il est possible d'utiliser des courbes prototypes indiquant les variations temporelles du signal.

L'entrée du modèle est composée de K signaux fonctions du temps, notés $S(t) = [S_1(t)...S_K(t)]^T$. Le modèle a pour sorties un jeu de P paramètres décrivant le mouvement dans le plan ou le volume d'intérêt, soit $\theta(t) = [\theta_1(t)... \theta_P(t)]^T$. Les sorties du modèle peuvent être soit des paramètres de transformation spatiale, tels que des paramètres de transformation affine, soit des champs de déplacements complets, échantillonnés sur une grille cartésienne par exemple, ou encore une combinaison des deux (transformation affine et déformations libres localement).

Le modèle est décrit par la relation suivante, moyennant une erreur $\varepsilon$ :

$$\begin{bmatrix} \theta_1(t) \\ \cdot \\ \cdot \\ \cdot \\ \theta_P(t) \end{bmatrix} = \begin{bmatrix} \alpha_{1,1} & \cdot & \cdot & \cdot & \alpha_{1,K} \\ \cdot & & & & \cdot \\ \cdot & & & & \cdot \\ \cdot & & & & \cdot \\ \alpha_{P,1} & \cdot & \cdot & \cdot & \alpha_{P,K} \end{bmatrix} \begin{bmatrix} S_1(t) \\ \cdot \\ \cdot \\ \cdot \\ S_K(t) \end{bmatrix} + \varepsilon(t) \qquad \text{(Eq. 20)}$$

Ou encore :

$$\theta(t) = \alpha.S(t) + \varepsilon(t) \qquad \text{(Eq. 21)}$$

Il est pour cela fait l'hypothèse que l'évolution temporelle des paramètres décrivant le mouvement peut être approchée par des combinaisons linéaires des signaux d'entrée.

Une fois les données d'entrée et de sortie obtenues, la détermination des coefficients du modèle linéaire, c'est-à-dire les coefficients de la matrice $\alpha$, est effectuée suivant une régression multivariable.

Cette étape de calibration initiale permet d'obtenir une première prédiction du mouvement de l'organe avant le début des itérations, et donc d'obtenir une optimisation convergeant plus rapidement.

Un dispositif d'IRM peut être utilisé pour exécuter la présente invention. Ce dispositif comporte des moyens d'acquisition et de traitement des images IRM, et met en oeuvre un procédé de correction des mouvements physiologiques en reconstruction IRM d'images conforme à l'une des variantes du procédé décrit ci-dessus. Un tel dispositif peut également utiliser le modèle établi par la reconstruction pour modifier son acquisition.

Le mode de mise en œuvre décrit ci-dessus de la présente invention est donné à titre d'exemple et n'est nullement limitatif. Il est entendu que l'homme du métier est à même de réaliser différentes variantes de l'invention sans pour autant sortir du cadre de l'invention tel que défini dans les revendications suivantes.

Les modes de réalisation précédemment décrits de la présente invention sont donnés à titre d'exemples et ne sont nullement limitatifs. Il est entendu que l'homme du métier est à même de réaliser différentes variantes ainsi que différentes combinaisons de ces modes de réalisation de l'invention sans pour autant sortir du cadre de l'invention tel que défini dans les revendications suivantes.

L'invention est applicable à d'autres problèmes inverses, par exemple pour d'autres signaux que des images, y compris en résonance magnétique nucléaire (RMN), où l'on peut acquérir des spectres (spectroscopie ou imagerie spectroscopique).

L'invention est uniquement définie par les revendications suivantes et n'est pas limitée aux exemples de réalisation décrits et illustrés. Selon d'autres modes particuliers de réalisations :

- un dispositif permettant l'acquisition de mesures expérimentales complémentaires est un analyseur de signal et contrôleur d'événement (SAEC).

- les événements relatifs à l'acquisition des mesures expérimentales d'intérêt premier et à l'acquisition des mesures expérimentales complémentaires, telles que les instants d'acquisition et l'ordre d'acquisition des données, sont synchronisés.

- le dispositif permettant l'acquisition de mesures expérimentales complémentaires comprend au moins un capteur externe et transmet ces mesures ainsi que les événements relatifs à l'acquisition de ces mesures à un module dédié au traitement de l'ensemble des données de mesures.

- le dispositif permettant l'acquisition de mesures expérimentales complémentaires comprend au moins un échonavigateur et transmet ces mesures ainsi que les événements relatifs à l'acquisition de ces mesures à un module dédié au traitement de l'ensemble des données de mesures.

- le dispositif d'acquisition de mesures expérimentales d'intérêt premier acquiert les mesures expérimentales d'intérêt premier, et transmet des données issues du traitement de ces mesures ainsi que les événements relatifs à l'acquisition de ces mesures à un module dédié au traitement de l'ensemble des données de mesures.

-, les mesures expérimentales complémentaires sont transmises à un module de préparation de données.

- le modèle de perturbation par le mouvement est décomposable en un ensemble de paramètres décrivant la dépendance spatiale du modèle et au moins une information corrélée au mouvement aux différents instants d'acquisition des mesures expérimentales.

- au moins un modèle de perturbation par le mouvement est linéaire, c'est-à-dire modélise l'évolution temporelle des paramètres décrivant le mouvement par des combinaisons linéaires de signaux issus des mesures expérimentales complémentaires.

- au moins un opérateur de sensibilité d'antennes est modélisé par au moins un modèle de perturbation de la sensibilité.

- au moins un modèle de perturbation de la sensibilité est décomposable en un ensemble de paramètre décrivant au moins une carte de sensibilité d'antenne.

- le procédé inclut un module dédié au traitement des données, opérant un tri des données de mesures expérimentales d'intérêt premier auxquelles sont appliquées des contraintes semblables, dans le cadre de la réduction du nombre de paramètres décrivant les modèles de simulation et de perturbation, ces contraintes semblables s'appuyant sur des données de mesures expérimentales complémentaires semblables. Ledit module dédié au traitement des données produit alors au moins une donnée expérimentale complémentaire triée et au moins un indice décrivant ledit tri des données de mesures expérimentales d'intérêt premier. De manière avantageuse, le module dédié au traitement des données transmet au moins un indice au module de préparation des données.

- au moins un indice est déterminé en quantifiant l'espace de variation de données de mesures expérimentales complémentaires afin d'obtenir un nombre restreint d'indices décrivant suffisamment les causes des perturbations.

- le procédé inclut un module de préparation de données qui, à l'aide de chaque indice, regroupe les mesures expérimentales élémentaires d'intérêt premier en ensembles correspondant aux sous-éléments distincts du modèle de simulation indexés par ce même indice.

- le module de préparation des données effectue une ou plusieurs prétransformations des acquisitions expérimentales élémentaires.

- la prétransformation est une transformée de Fourier dans la ou les directions indépendantes de la perturbation par le mouvement, permettant de simplifier d'autant l'opérateur d'encodage en transformée de Fourier du modèle de simulation.

- l'opérateur d'au moins un modèle de simulation est décomposé en sous-éléments indexés par les indices produits par le module de traitement de données externes.

- les acquisitions expérimentales élémentaires d'intérêt premier, regroupées en ensembles indexés, sont les données expérimentales perturbées à reconstruire.

- les données des mesures expérimentales complémentaires triées sont les données expérimentales complémentaires utilisées pour contraindre le modèle de perturbation par le mouvement.

- pour chaque modèle de perturbation, la différence entre les paramètres optimaux et les paramètres actuels du modèle de perturbation est l'erreur sur les paramètres du modèle de perturbation. Ledit résidu de reconstruction est modélisé par un opérateur résidu s'appliquant à l'erreur sur les paramètres du modèle de perturbation. Cet opérateur résidu est fonction des paramètres actuels des modèles de simulations et de perturbations.

- pour des erreurs sur les paramètres du modèle de perturbation petites, ledit opérateur résidu est linéaire.

- pour le modèle de perturbation par le mouvement selon l'invention, en introduisant l'hypothèse de conservation locale du signal, et en utilisant un modèle linéaire de perturbation par le mouvement tel que décrit précédemment, l'opérateur résidu est composé des opérateurs linéaires apparaissant dans l'opérateur de simulation, et d'une composition du gradient du signal actuel et des données de mesures expérimentales complémentaires.

- pour le modèle de perturbation de la sensibilité, en utilisant le fait que l'expression des variations de sensibilité est diagonale, l'opérateur de résidu s'écrit de la même manière que l'opérateur de simulation en remplaçant l'opérateur de sensibilité par un opérateur diagonal, dont la diagonale est constituée de la résultante de la composition du signal actuel par l'opérateur de translation.

- l'optimisation des paramètres du modèle de perturbation est réalisée par la résolution du problème inverse décrit par l'opérateur résidu, prenant pour entrée ledit résidu de reconstruction et fournissant en sortie une estimation des erreurs faites sur les paramètres du modèle de perturbation. Une fois obtenues, ces erreurs faites sur les paramètres du modèle de perturbation sont utilisées pour actualiser les paramètres du modèle de perturbation.

- la résolution du problème inverse est effectuée par une méthode itérative ne nécessitant pas la connaissance explicite de l'opérateur hermitien complet.

- ladite méthode itérative est une méthode de Krylov, telle que le gradient conjugué, le Résidu Minimal Généralisé (GMRES), ou le gradient biconjugué.

- la résolution du problème inverse comprend au moins une régularisation.

- la contrainte de régularisation est de type régularisation de Tikhonov sur les paramètres du modèle de perturbation additionnés des erreurs sur les paramètres du modèle de perturbation

- la contrainte de régularisation est de type contrainte sur le gradient spatial des paramètres du modèle de perturbation additionnés des erreurs sur les paramètres du modèle de perturbation, de type contrainte de Tikhonov ou contrainte de la variation totale.

- pour la résolution des problèmes inverses pour l'optimisation des paramètres des modèles de simulation et de perturbation effectuée par une méthode itérative, le calcul des sous-ensembles des opérateurs est parallélisé sur des calculateurs distincts.

- l'optimisation couplée desdits paramètres des modèles de simulations et de perturbations est réalisée par une méthode dite point fixe, c'est-à-dire dans laquelle chaque modèle est optimisé séparément, tous les autres étant considérés fixés.

- le signal est une image IRM multidimensionnelle, en particulier 2D et 3D.
les choix d'initialisations des paramètres des modèles de simulations et de perturbations sont dérivés d'acquisitions dites de « calibration » obtenues à partir du dispositif d'acquisition des mesures expérimentales d'intérêt premier et éventuellement du dispositif d'acquisition des mesures expérimentales complémentaires.

- le procédé de l'invention est inclus dans un système où le dispositif d'acquisition des données expérimentales contient des paramètres ajustables, et où les opérateurs décrivant les différents modèles de simulation et de perturbations prennent en compte cette possibilité d'ajustement.

- les paramètres ajustables sont des fonctions des paramètres des modèles de perturbations optimisés.

- les paramètres ajustables sont actualisés une fois les paramètres optimaux des modèles de simulations et de perturbations établis.

- l'actualisation desdits paramètres ajustables est répétée selon une itération régie par une condition d'arrêt.

- le paramètre ajustable est la résolution de l'image IRM, et la fonction d'actualisation des paramètres est le doublement de la résolution actuelle de l'image optimale, la condition d'arrêt étant la taille prédéfinis.

- les paramètres d'ajustement sont des paramètres de transformation affine du volume d'acquisition IRM, et la fonction d'actualisation est un modèle de transformation affine du volume d'acquisition IRM dépendant en temps réel des mesures expérimentales complémentaires, dont les paramètres sont ajustés à partir des transformations affines estimées sur une région d'intérêt, par exemple déduites des paramètres du modèle de perturbation par le mouvement. Dans un mode de réalisation particulier, la condition d'arrêt est un nombre d'itérations prédéfini.

- Lorsqu'un modèle de perturbation comprend un nombre important de paramètres, ce nombre de paramètres peut être réduit, par exemple, à l'aide d'une contrainte supplémentaire fournie par des mesures expérimentales complémentaires, telle que par exemple une contrainte exploitant la corrélation des paramètres du modèle de perturbation avec des signaux issus d'enregistrements physiologiques, tels que des signaux dérivés de capteurs respiratoires, d'électrocardiogrammes (ECG), ou de navigateurs IRM.

## Revendications

**1.** Procédé d'acquisition (1) de mesures expérimentales perturbées, d'un phénomène physique et de reconstruction (2) d'un premier signal (3) représentant ce phénomène physique, lesdites mesures expérimentales étant obtenues d'un sujet ou objet par résonance magnétique du groupe composé de l'IRM, de la spectroscopie RMN ou par l'imagerie médicale telle que scanner ou PET, l'acquisition étant perturbée par un mouvement du sujet ou objet pendant l'acquisition, ledit procédé d'acquisition mettant en oeuvre :

- au moins une acquisition de mesures expérimentales par au moins une chaine d'acquisition par résonance magnétique ou imagerie médicale desdites mesures expérimentales, appelées mesures d'intérêt premier, laquelle chaine d'acquisition comprenant au moins une perturbation par ledit mouvement,
- au moins un modèle de simulation (4) de ladite chaîne d'acquisition, lequel modèle de simulation (4) prenant en entrée un deuxième signal (6) sous une forme choisie parmi un voxel, une image, une pile d'images et un volume d'IRM ou d'imagerie médicale et fournissant en sortie des données expérimentales simulées (7), et
- au moins un modèle de perturbation (8) de ladite perturbation de ladite chaîne d'acquisition, lequel modèle de perturbation (8) étant déterminé au moins à partir des mesures expérimentales elles-mêmes,

ledit procédé étant tel que lesdits modèles de simulation (4) et de perturbation (8) comprennent des paramètres ajustables (6,10) dépendants des mesures expérimentales,
lesdits modèles de simulation (4) et de perturbation (8) sont couplés dans le sens où le modèle de simulation (4) dépend (5) du paramètre ajustable (10) du modèle de perturbation (8), ledit procédé étant **caractérisé en ce que** lesdits paramètres ajustables (6,10) sont optimisés (2) de manière couplée, ladite optimisation fournissant, en sortie, le premier signal (3) et les paramètres (15) du modèle de perturbation, ladite optimisation réalisant une reconstruction dudit premier signal (3), **en ce que** l'optimisation desdits paramètres (6) du modèle de simulation (4) est réalisée par résolution du problème inverse du modèle de simulation (31), en prenant pour entrées les mesures expérimentales (13) et en résolvant le problème à symétrie hermitienne équivalent, **en ce que** le signal (6) issu de la résolution du problème inverse du modèle de simulation (31) est utilisé pour générer un résultat du modèle de simulation (7), la différence entre lesdites mesures expérimentales d'intérêt premier et ledit résultat du modèle de simulation (7) est utilisée comme critère d'optimisation desdits modèles de simulation (4) et de perturbation (8) couplés, et un résidu de reconstruction (32) est calculé à partir de la différence entre des mesures expérimentales d'intérêt premier et ledit résultat du modèle de simulation (7), et **en ce que** ledit résidu de reconstruction (32) est modélisé par un opérateur résidu, lequel opérateur résidu prenant pour entrée une estimation des erreurs (35) faites sur les paramètres du modèle de perturbation par le mouvement et fournissant en sortie ledit résidu de reconstruction (32), et étant fonction des paramètres actuels (9, 34) des modèles de simulation et de perturbation par le mouvement.

2. Procédé selon la revendication 1, **caractérisé en ce qu'**il met en œuvre des moyens permettant l'acquisition de mesures expérimentales complémentaires auxdites mesures d'intérêt premier.

3. Procédé selon la revendication 1 ou 2, **caractérisé en ce que** l'optimisation (2) desdits paramètres ajustables (6,10) des modèles de simulation (4) et de perturbation (8) est réalisée en utilisant l'une des fonctions de coût (16) suivantes :

   - une fonction de coût (16) quantifiant le niveau de perturbation du signal et des paramètres ajustables desdits modèles,
   - une fonction de coût (16) quantifiant l'écart entre au moins une partie du signal issu des mesures expérimentales et au moins une partie du signal correspondant reconstruit par au moins un modèle de simulation (4).

4. Procédé selon l'une quelconque des revendications précédentes, **caractérisé en ce que** l'optimisation (2) desdits paramètres ajustables (6,10) des modèles de simulation (4) et de perturbation (8) comprend au moins une étape de minimisation d'un résidu de reconstruction défini comme l'écart entre au moins une partie du signal issu des mesures expérimentales, et au moins une partie du signal correspondant reconstruit par au moins un modèle de simulation (4).

5. Procédé selon l'une quelconque des revendications précédentes, **caractérisé en ce que** ledit modèle de simulation (4) est réalisé sous la forme d'un opérateur linéaire.

6. Procédé selon l'une quelconque des revendications précédentes, **caractérisé en ce que** la résolution dudit problème inverse du modèle de simulation (31) est effectuée par une méthode itérative ne nécessitant pas la connaissance explicite de l'opérateur hermitien complet, telle que le gradient conjugué, le Résidu Minimal Généralisé (GMRES) ou le gradient biconjugué.

7. Procédé selon l'une quelconque des revendications précédentes, **caractérisé en ce que** ledit opérateur résidu comprend des opérateurs linéaires apparaissant dans l'opérateur de simulation (17), et une composition d'un gradient du signal actuel $\rho$ (6) et des données de mesures expérimentales complémentaires.

8. Procédé selon l'une quelconque des revendications précédentes, **caractérisé en ce que** :

   - l'optimisation des paramètres du modèle de perturbation (8) est réalisée par la résolution du problème inverse (33) décrit par ledit opérateur résidu, laquelle résolution du problème inverse étant effectuée en résolvant le problème à symétrie hermitienne équivalent,
   - ladite estimation des erreurs (35) faites sur les paramètres du modèle de perturbation est utilisée pour actualiser les paramètres du modèle de perturbation (8).

9. Procédé selon la revendication 8, **caractérisé en ce que** ladite résolution du problème inverse (33) décrit par l'opérateur résidu est effectuée par une méthode itérative ne nécessitant pas la connaissance explicite de l'opérateur hermitien complet, telle que le gradient conjugué, le Résidu Minimal Généralisé (GMRES) ou le gradient biconjugué, et **en ce qu'**elle comprend une régularisation de l'un des types suivants :

   - Régularisation de Tikhonov portant sur les paramètres du modèle de perturbation (34) additionnés des erreurs sur les paramètres dudit modèle de perturbation,
   - Contrainte sur le carré de la norme du gradient spatial des paramètres du modèle de perturbation additionné des erreurs sur les paramètres dudit modèle de perturbation.

10. Procédé selon l'une quelconque des revendications précédentes, **caractérisé en ce que** l'optimisation desdits paramètres desdits modèles de simulation (4) et de perturbation (8) est réalisée par une méthode de point fixe,

   - chaque modèle étant optimisé séparément, tous les autres étant considérés fixés, et

- laquelle optimisation étant réalisée de manière alternée sur chaque modèle.

**11.** Procédé de reconstruction selon la revendication 10, **caractérisé en ce que** ladite optimisation des paramètres des modèles de simulation (4) et de perturbation (8) est répétée selon une itération primaire (57),

- les paramètres optimaux étant ceux donnant le plus petit résidu (32), et
- ladite itération primaire (57) étant régie par une condition d'arrêt (58), laquelle étant établie par l'un quelconque des critères suivants : La différence entre lesdits résidus (32) lors de deux incrémentations distinctes de l'itération primaire (57), une valeur minimale prédéterminée dudit résidu (32), ou un nombre d'itérations prédéterminé.

**12.** Procédé selon l'une quelconque des revendications 10 ou 11, **caractérisé en ce que** ladite optimisation des paramètres des modèles de simulation (4) et de perturbation (8) est répétée selon une itération secondaire (59) multi-résolutions établie sur la base d'un niveau de résolution du premier signal (3).

**13.** Procédé selon l'une quelconque des revendications 2 à 12, **caractérisé en ce que** le modèle de simulation (4) est réalisé sous la forme d'un opérateur linéaire (17) comprenant :

- un opérateur de transformation spatiale (19), modélisé par ledit modèle de perturbation (8) par le mouvement.
- un opérateur de pondération en sensibilité d'antenne (20),
- un opérateur d'encodage (21), et
- un opérateur d'échantillonnage (22) sur grille cartésienne.

**14.** Procédé selon la revendication 13, **caractérisé en ce que** ledit opérateur de transformation spatiale (19) est un opérateur de transformation spatiale élastique permettant la prise en compte de déformations localement libres.

**15.** Procédé selon la revendication 13 ou 14, **caractérisé en ce que** ledit opérateur de transformation spatiale (19) est modélisé par au moins un modèle de perturbation par le mouvement,

- lequel mouvement perturbant les mesures expérimentales d'intérêt premier,
- lequel modèle de perturbation par le mouvement étant décomposable en un ensemble de paramètres décrivant la dépendance spatiale du modèle, et au moins une information corrélée au mouvement aux différents instants d'acquisition des mesures expérimentales,
- lequel modèle de perturbation par le mouvement étant linéaire, modélisant l'évolution temporelle des paramètres décrivant le mouvement par des combinaisons linéaires de signaux issus desdites mesures expérimentales complémentaires.

**16.** Procédé selon la revendication 15, **caractérisé en ce que** lesdites mesures expérimentales complémentaires sont utilisées pour contraindre le modèle de perturbation par le mouvement.

**17.** Procédé selon l'une quelconque des revendications 13 à 16, **caractérisé en ce que** ledit opérateur de pondération en sensibilité d'antenne (20) est modélisé par au moins un modèle de perturbation de la sensibilité, lequel modèle de perturbation de la sensibilité étant décomposable en un ensemble de paramètres décrivant au moins une carte de sensibilité d'antenne, et **en ce que** l'opérateur de résidu (39) s'écrit de la même manière que l'opérateur de simulation (17) en remplaçant ledit opérateur de pondération en sensibilité d'antenne (20) par un opérateur diagonal, dont la diagonale est constituée de la résultante de la composition du signal actuel (6) par un opérateur de transformation spatiale (19).

**18.** Procédé selon l'une quelconque des revendications 13 à 17, **caractérisé en ce que** ledit opérateur d'encodage (21) est un opérateur de type transformée de Fourier.

**19.** Procédé selon l'une quelconque des revendications 2 à 18, **caractérisé en ce qu'**il comprend une étape d'acquisition des données et de préparation de la reconstruction (25), laquelle étape comprenant :

- ladite au moins une acquisition de mesures expérimentales (1) d'intérêt premier,
- et une acquisition de mesures expérimentales complémentaires (26), lesquelles mesures expérimentales complémentaires provenant au moins de l'un parmi un capteur externe, un écho-navigateur, et des mesures expérimentales d'intérêt premier,
- la synchronisation des événements relatifs à l'acquisition des mesures expérimentales d'intérêt premier et à l'acquisition des mesures expérimentales complémentaires, tels que les instants d'acquisition et l'ordre d'acquisition des données.

**20.** Procédé selon la revendication 19, **caractérisé en ce que** la préparation de la reconstruction (25) comprend une opération de tri des mesures expérimentales d'intérêt premier auxquelles sont appliquées des contraintes semblables,

- lesdites contraintes semblables s'appuyant sur des données de mesures expérimentales complémentaires semblables,
- ladite opération de tri produisant au moins une donnée expérimentale complémentaire triée et au moins un ensemble d'indices d'intérêt décrivant ledit tri des données de mesures expérimentales d'intérêt premier,
- lesdites mesures expérimentales d'intérêt premier étant regroupées en au moins un ensemble correspondant audit ensemble d'indices d'intérêt.

**21.** Procédé selon la revendication 20, **caractérisé en ce qu'**au moins un ensemble d'indices d'intérêt est déterminé en opérant une quantification de l'espace de variation des données de mesures expérimentales complémentaires.

**22.** Procédé selon l'une quelconque des revendications 19 à 21, **caractérisé en ce que** ladite préparation de la reconstruction (25) comprend au moins une pré-transformations des mesures expérimentales d'intérêt premier, telle qu'une transformée de Fourier dans la ou les directions indépendantes de la perturbation par le mouvement.

**23.** Procédé selon l'une quelconque des revendications 20 à 22, **caractérisé en ce que** l'opérateur du modèle de simulation (4) est décomposé en au moins un sous-élément indexé par lesdits indices d'intérêt,

- lesdites acquisitions expérimentales d'intérêt premier, regroupées en ensembles indexés, étant les données expérimentales perturbées à reconstruire (13),
- lesdites données issues des mesures expérimentales complémentaires triées selon lesdits indices d'intérêt étant les données expérimentales complémentaires (12) utilisées pour contraindre ledit modèle de perturbation par le mouvement.

**24.** Procédé selon l'une quelconque des revendications 2 à 23, **caractérisé en ce qu'**il comprend des paramètres d'acquisition ajustables (46),

- lesdits paramètres d'acquisition ajustables étant pris en compte par les modèles de simulation et de perturbation,
- lesdits paramètres d'acquisition ajustables étant fonction des paramètres des modèles de perturbations optimisés,
- lesdits paramètres d'acquisition ajustables étant mis à jour après que les paramètres optimaux desdits modèles de simulation et de perturbation soient établis (55),
- ladite mise à jour desdits paramètres d'acquisition ajustables étant répétée selon une itération régie par une condition d'arrêt.

**25.** Procédé selon la revendication 24, **caractérisé en ce que**

- lesdits paramètres d'acquisition ajustables sont des paramètres de transformation affine d'un volume d'acquisition IRM,
- ladite mise à jour desdits paramètres d'acquisition ajustables est un modèle de transformation affine d'un volume d'acquisition IRM dépendant en temps réel des mesures expérimentales complémentaires.

**26.** Procédé selon l'une quelconque des revendications 1 à 23, **caractérisé en ce que** lesdites mesures expérimentales sont issues d'un processus RMN et ledit premier signal (3) est reconstruit sous la forme d'au moins un spectre d'au moins un voxel de spectroscopie par RMN.

**27.** Procédé selon l'une quelconque des revendications 1 à 17 et 19 à 24, **caractérisé en ce que** ledit premier signal (3) est reconstruit sous une forme choisie parmi un voxel, une image, une pile d'images et un volume et lesdites mesures expérimentales sont issues d'un processus d'acquisition d'images médicales choisi parmi la tomographie par rayons X, la Tomographie par Emission de Positons, la tomographie d'émission monophotonique et l'échographie.

**Patentansprüche**

1. Verfahren zur Erfassung (1) gestörter experimenteller Messdaten eines physikalischen Phänomens und zur Rekonstruktion (2) eines ersten Signals (3), das dieses physikalische Phänomen beschreibt, wobei die experimentellen Messdaten eines Subjekts oder Objekts mittels eines Magnetresonanzverfahrens, das ausgewählt ist aus der Gruppe, die MRT, Kernspinresonanzspektroskopie oder medizinische Bildgebung wie Computertomografie oder PET erhält, wobei die Erfassung durch eine Bewegung des Subjekts oder Objekts während der Erfassung gestört wird, wobei das Verfahren das Folgende aufweist:

   - zumindest eine Erfassung von experimentellen Messdaten durch zumindest eine Erfassungskette durch Magnetresonanz oder medizinische Bildgebung der experimentellen, als primär interessierende Messdaten bezeichneten, Messdaten, wobei die Erfassungskette zumindest eine Störung durch die Bewegung aufweist,
   - zumindest ein Simulationsmodell (4) der Erfassungskette, wobei im Eingang in dem Simulationsmodell (4) ein zweites Signal (6) verwendet wird, das ausgewählt ist aus einer Gruppe, die ein Voxel, ein Bild, ein Bilderstack und ein MRT-Volumen oder medizinischem Bildgebungsvolumen besteht, und am Ausgang simulierte experimentelle Daten (7) bereitstellt, und
   - zumindest ein Störungsmodell (8) der Störung der Erfassungskette, wobei das Störungsmodell (8) zumindest ausgehend von den experimentellen Messdaten selbst bestimmt ist,

   wobei bei dem Verfahren
   das Simulationsmodell (4) und das Störungsmodell (8) anpassbare, von den experimentellen Messdaten abhängige Parameter (6, 10) aufweisen, das Simulationsmodell (4) und das Störungsmodell (8) in dem Sinne gekoppelt sind, dass das Simulationsmodell (4) von dem anpassbaren Parameter (10) des Störungsmodells (8) abhängt (5),
   wobei das Verfahren **dadurch gekennzeichnet ist, dass** die anpassbaren Parameter (6, 10) auf gekoppelte Weise optimiert (2) sind,
   wobei die Optimierung am Ausgang das erste Signal (3) und die Parameter (15) des Störungsmodells bereitstellt,
   wobei die Optimierung eine Rekonstruktion des ersten Signals (3) durchführt,
   und dadurch, dass
   die Optimierung der Parameter (6) des Simulationsmodells (4) durch die Lösung des inversen Problems des Simulationsmodells (31) durchgeführt wird, indem im Eingang die experimentellen Messdaten (13) verwendet werden und das äquivalente Problem hermitescher Symmetrie gelöst wird, und dadurch, dass
   das aus der Lösung des inversen Problems des Simulationsmodells (31) stammende Signal (6) verwendet wird, um ein Ergebnis des Simulationsmodells (7) zu generieren, wobei die Abweichung zwischen den primär interessierenden experimentellen Messdaten und dem Ergebnis des Simulationsmodells (7) als Optimierungskriterium für die Kopplung aus Simulationsmodell (4) und Störungsmodell (8) genutzt wird und wobei ein Rekonstruktionsresiduum (32) ausgehend von der Abweichung zwischen den primär interessierenden experimentellen Messdaten und dem Ergebnis des Simulationsmodells berechnet wird, und dadurch, dass
   das Rekonstruktionsresiduum (32) durch einen Residuumsoperator modelliert wird, wobei als Eingang für den Residuumsoperator eine Fehlerabschätzung (35) der Fehler verwendet wird, die bei den Parametern des Störungsmodells durch die Bewegung gemacht werden, und wobei am Ausgang das Rekonstruktionsresiduum (32) bereitgestellt wird, und der eine Funktion der aktuellen Parameter (9, 34) des Simulationsmodells und des Störungsmodells durch die Bewegung ist.

2. Verfahren nach Anspruch 1, **dadurch gekennzeichnet, dass** Mittel verwendet werden, die die Erfassung von zu den primär interessierenden Messdaten komplementären Messdaten ermöglichen.

3. Verfahren nach Anspruch 1 oder 2, **dadurch gekennzeichnet, dass** die Optimierung (2) der anpassbaren Parameter (6, 10) des Simulationsmodells (4) und des Störungsmodells (8) mittels einer der folgenden Kostenfunktionen (16) durchgeführt wird:

   - einer Kostenfunktion (16), die das Ausmaß der Störung des Signals und der anpassbaren Parameter der Modelle quantifiziert,
   - eine Kostenfunktion (16), die den Abstand zwischen zumindest einem Teil des aus den experimentellen Messdaten stammenden Signals und zumindest einem Teil des entsprechenden, durch zumindest ein Simulationsmodell (4) rekonstruierten Signals quantifiziert.

4. Verfahren nach einem der vorstehenden Ansprüche, **dadurch gekennzeichnet, dass** die Optimierung (2) der anpassbaren Parameter (6, 10) des Simulationsmodells (4) und des Störungsmodells (8) zumindest einen Schritt der Minimierung eines als Abstand zwischen zumindest einem Teil des aus den experimentellen Messdaten stammenden Signals und zumindest eines Teils des entsprechenden, durch zumindest ein Simulationsmodell (4) rekonstruierten Signals definierten Rekonstruktionsresiduums aufweist.

5. Verfahren nach einem der vorstehenden Ansprüche, **dadurch gekennzeichnet, dass** das Simulationsmodell (4) als linearer Operator realisiert wird.

6. Verfahren nach einem der vorstehenden Ansprüche, **dadurch gekennzeichnet, dass** die Lösung des inversen Problems des Simulationsmodells (31) durch eine iterative Methode ausgeführt wird, die keine explizite Kenntnis des vollständigen hermiteschen Operators erfordert, etwa das Konjugierte-Gradienten-Verfahren, das GMRES-Verfahren oder das BiCG-Verfahren.

7. Verfahren nach einem der vorstehenden Ansprüche, **dadurch gekennzeichnet, dass** der Residuumsoperator lineare Operatoren, die in dem Simulationsoperator (17) auftreten, und eine Verknüpfung eines Gradienten des aktuellen Signals p (6) und der Daten der komplementären experimentellen Messdaten aufweist.

8. Verfahren nach einem der vorstehenden Ansprüche, **dadurch gekennzeichnet, dass**:

   - die Optimierung der Parameter des Störungsmodells (8) durch die Lösung des inversen Problems (33), das durch den Residuumsoperator beschrieben wird, realisiert wird, wobei die Lösung des inversen Problems durch Lösung des Problems äquivalenter hermitescher Symmetrie durchgeführt wird,
   - die auf den Parametern des Störungsmodells ausgeführte Fehlerabschätzung (35) genutzt wird, um die Parameter des Störungsmodells (8) zu aktualisieren.

9. Verfahren nach Anspruch 8, **dadurch gekennzeichnet, dass** die Lösung des inversen Problems (33), das durch den Residuumsoperator beschrieben wird, durch eine iterative Methode ausgeführt wird, die keine explizite Kenntnis des vollständigen hermiteschen Operators erfordert, etwa das Konjugierte-Gradienten-Verfahren, das GMRES-Verfahren oder das BiCG-Verfahren, und dass es eine Regularisierung einer der folgenden Arten aufweist:

   - Tikhonov-Regularisierung betreffend die Parameter des Störungsmodells (34) zuzüglich der Fehler in den Parametern des Störungsmodells,
   - Nebenbedingung des Quadrats der Norm des räumlichen Gradienten der Parameter des Störungsmodells zuzüglich der Fehler auf den Parametern des Störungsmodells.

10. Verfahren nach einem der vorstehenden Ansprüche, **dadurch gekennzeichnet, dass** die Optimierung der Parameter des Simulationsmodells (4) und des Störungsmodells (8) mittels einer Fixpunktmethode durchgeführt wird,

   - wobei jedes Modell getrennt optimiert wird und alle anderen als fixiert angesehen werden, und
   - die jeweilige Optimierung in alternierender Weise auf jedem Modell durchgeführt wird.

11. Rekonstruktionsverfahren nach Anspruch 10, **dadurch gekennzeichnet, dass** die Optimierung der Parameter des Simulationsmodells (4) und des Störungsmodells (8) einer primären Iteration (57) folgend wiederholt wird,

   - wobei die optimalen Parameter dabei diejenigen sind, die das kleinste Residuum (32) ergeben, und
   - die primäre Iteration (57) eine Abbruchbedingung (58) hat, wobei diese mittels eines der folgenden Kriterien festgelegt wird: der Differenz zwischen den Residuen (32) bei zwei voneinander getrennten Inkrementen der primären Iteration (57), einem vorbestimmten minimalen Wert des Residuums (32), oder einer vorbestimmten Anzahl an Iterationen.

12. Verfahren nach einem der Ansprüche 10 oder 11, **dadurch gekennzeichnet, dass** die Optimierung der Parameter des Simulationsmodells (4) und des Störungsmodells (8) gemäß einer sekundären Iteration (59) in mehrfacher Auflösung wiederholt wird, die auf der Grundlage eines Auflösungsniveaus des ersten Signals (3) etabliert wird.

13. Verfahren nach einem der Ansprüche 2 bis 12, **dadurch gekennzeichnet, dass** das Simulationsmodell (4) realisiert wird als Linearoperator (17), der das Folgende aufweist:

   - einen durch das Störungsmodell (8) der Bewegung modellierter räumlicher Transformationsoperator (19),
   - einen Bewertungsoperator der Antennenempfindlichkeit (20),

- einen Kodierungsoperator (21), und
- einen Samplingoperator (22) auf einem kartesischem Gitter.

14. Verfahren nach Anspruch 13, **dadurch gekennzeichnet, dass** der räumliche Transformationsoperator (19) ein elastischer räumlicher Transformationsoperator ist, der die Berücksichtigung der freien lokalen Verformungen ermöglicht.

15. Verfahren nach Anspruch 13 oder 14, **dadurch gekennzeichnet, dass** der räumliche Transformationsoperator (19) durch zumindest ein Störungsmodell durch Bewegung modelliert ist, wobei

- diese Bewegung die primär interessierenden experimentellen Messdaten stört,
- dieses Störungsmodell durch Bewegung zerlegbar ist in ein Ensemble an Parametern, das die räumliche Abhängigkeit des Modells beschreibt, und in zumindest eine Information, die mit der Bewegung zu unterschiedlichen Erfassungszeitpunkten der experimentellen Messdaten korreliert ist,
- das Störungsmodell durch Bewegung linear ist und die zeitliche Entwicklung der Parameter, die die Bewegung beschreiben, durch Linearkombinationen der aus den experimentellen Messdaten stammenden Signalen modelliert.

16. Verfahren nach Anspruch 15, **dadurch gekennzeichnet, dass** die komplementären experimentellen Messdaten genutzt werden, um Nebenbedingungen für das Störungsmodell durch Bewegung zu erstellen.

17. Verfahren nach einem der Ansprüche 13 bis 16, **dadurch gekennzeichnet, dass** der Bewertungsoperator der Antennenempfindlichkeit (20) durch zumindest ein Modell der Störung der Empfindlichkeit modelliert wird, wobei das Modell der Störung der Empfindlichkeit in eine Parametermenge zerlegbar ist, die zumindest eine Karte der Antennenempfindlichkeit beschreiben, und dass der Residuumsoperator (39) sich auf die gleiche Weise wie der Simulationsoperator (17) formuliert ist, wobei der Bewertungsoperator der Antennenempfindlichkeit (20) durch einen diagonalen Operator ersetzt wird, wobei dessen Diagonale durch die Resultierende der Zusammensetzung des aktuellen Signals (6) durch einen räumlichen Transformationsoperator (19) gebildet wird.

18. Verfahren nach einem der Ansprüche 13 bis 17, **dadurch gekennzeichnet, dass** der Kodierungsoperator (21) ein Operator des Typs einer Fourier-Transformierten ist.

19. Verfahren nach einem der Ansprüche 2 bis 18, **dadurch gekennzeichnet, dass** es einen Schritt der Erfassung der Daten und der Vorbereitung der Rekonstruktion (25) aufweist, wobei dieser Schritt das Folgende aufweist:

- zumindest eine Erfassung der primär interessierenden experimentellen Messdaten (1),
- und eine Erfassung von komplementären experimentellen Messdaten (26), wobei die komplementären experimentellen Messdaten von zumindest einem aus einem externen Empfänger, einem Echo-Navigator, und primär interessierenden experimentellen Messdaten stammen,
- die Synchronisierung der Ereignisse im Zusammenhang mit der Erfassung der primär interessierenden experimentellen Messdaten und der Erfassung der komplementären Messdaten, etwa die Erfassungszeitpunkte und die Erfassungsreihenfolge der Daten.

20. Verfahren nach Anspruch 19, **dadurch gekennzeichnet, dass** die Vorbereitung der Rekonstruktion (25) eine Sortierung der primär interessierenden experimentellen Messdaten aufweist, an die gleichartige Nebenbedingungen gestellt werden,

- wobei sich die gleichartigen Nebenbedingungen auf die Daten gleichartiger komplementärer experimenteller Messdaten stützen,
- die Sortierung zumindest einen sortierten komplementären Datensatz ergibt und zumindest eine Gruppe von primär interessierenden Indices, die die Sortierung der Daten der primär interessierenden experimentellen Messdaten beschreiben,
- wobei die primär interessierenden experimentellen Messdaten in einer der Gruppe von primär interessierenden Indices entsprechenden Gruppe gruppiert sind.

21. Verfahren nach Anspruch 20, **dadurch gekennzeichnet, dass** zumindest ein Ensemble primär interessierender Indices durch eine Quantifizierung des Variationsraums der Daten der komplementären experimentellen Messdaten bestimmt wird.

**22.** Verfahren nach einem der Ansprüche 19 bis 21, **dadurch gekennzeichnet, dass** die Vorbereitung der Rekonstruktion (25) zumindest eine Vortransformation der primär interessierenden experimentellen Messdaten aufweist, etwa eine Fourier-Transformation in der oder den von der Störung durch Bewegung unabhängigen Richtungen.

**23.** Verfahren nach einem der Ansprüche 20 bis 22, **dadurch gekennzeichnet, dass** der Operator des Simulationsmodells (4) in zumindest ein durch die primär interessierenden Indizes indiziertes Unterelement zerlegt wird,

- wobei die als indizierte Ensembles gruppierten primär interessierenden experimentellen Erfassungen die zu rekonstruierenden gestörten experimentellen Daten sind,
- wobei die aus den gemäß den primär interessierenden Indizes sortierten komplementären experimentellen Messdaten stammenden Daten die für das Erstellen der Nebenbedingungen an das Störungsmodell durch Bewegung genutzten komplementären experimentellen Messdaten (12) sind.

**24.** Verfahren nach einem der Ansprüche 2 bis 23, **dadurch gekennzeichnet, dass** es anpassbare Erfassungsparameter (46) aufweist,

- wobei die anpassbaren Erfassungsparameter von dem Simulationsmodell und dem Störungsmodell berücksichtigt werden,
- die anpassbaren Erfassungsparameter eine Funktion der optimierten Störungsmodellparameter sind,
- wobei die anpassbaren Erfassungsparameter aktualisiert werden, nachdem die optimalen Parameter des Simulationsmodells und des Störungsmodells festgelegt sind (55),
- die Aktualisierung der anpassbaren Erfassungsparameter gemäß einer durch eine Abbruchbedingung beherrschten Iteration wiederholt wird.

**25.** Verfahren nach Anspruch 24, **dadurch gekennzeichnet, dass**

- die anpassbaren Erfassungsparameter die Parameter einen affinen Transformation eines MRT-Erfassungsvolumens sind,
- die Aktualisierung der anpassbaren Erfassungsparameter ein affines Transformationsmodell eines MRT-Erfassungsvolumens ist, das in Echtzeit von den komplementären experimentellen Messdaten abhängt.

**26.** Verfahren nach einem der Ansprüche 1 bis 23, **dadurch gekennzeichnet, dass** die experimentellen Messdaten aus einem Kernspinresonanz-Prozess entstammen und das erste Signal (3) als zumindest ein Spektrum zumindest eines Kernspinresonanzspektroskopie-Voxels rekonstruiert wird.

**27.** Verfahren nach einem der Ansprüche 1 bis 17 und 19 bis 24, **dadurch gekennzeichnet, dass** das erste Signal (3) in einer aus einem Voxel, einem Bild, einem Bilderstack und einem Volumen ausgewählten Form rekonstruiert wird und die experimentellen Messdaten einem medizinischem Bildgebungsverfahren entstammen, das aus der Röntgentomographie, der PET, der monophotonischen Emissionstomographie und der Echographie ausgewählt wird.

**Claims**

**1.** Method for acquiring (1) distorted experimental measurements of a physical phenomenon and reconstructing (2) a first signal (3) representing this physical phenomenon, said experimental measurements being obtained from a subject or object by magnetic resonance from the group composed of MRI, NMR spectroscopy or medical imaging such as CT scanning or PET scanning, the acquisition being distorted by a motion of the subject or object during the acquisition, said acquisition method implementing:

- at least one acquisition of experimental measurements by at least one chain of acquisition by magnetic resonance or medical imaging of said experimental measurements, called measurements of primary interest, said acquisition chain comprising at least one distortion caused by said motion,
- at least one model for simulating (4) of said acquisition chain, said simulation model (4) taking, as input, a second signal (6) in a form chosen from a voxel, an image, an image stack and an MRI volume or medical imaging volume and supplying, as output, simulated experimental data (7), and
- at least one distortion model (8) of said distortion of said acquisition chain, said distortion model (8) being determined at least from the experimental measurements themselves, said method being such that

said simulation (4) and distortion (8) models comprise adjustable parameters (6, 10) dependent on the experimental measurements,

said simulation (4) and distortion (8) models are coupled in the sense that the simulation model (4) depends (5) on the adjustable parameter (10) of the distortion model (8), said method being **characterized in that**

said adjustable parameters (6, 10) are optimized (2) in a coupled manner, said optimization supplying, as output, the first signal (3) and the parameters (15) of the distortion model, said optimization producing a reconstruction of said first signal (3),

**in that** the optimization of said parameters (6) of the simulation model (4) is produced by solving the inverse problem of the simulation model (31), taking the experimental measurements (13) as inputs and solving the equivalent Hermitian symmetry problem,

**in that** the signal (6) originating from the solution of the inverse problem of the simulation model (31) is used to generate a result of the simulation model (7), the difference between said experimental measurements of primary interest and said result of the simulation model (7) is used as a criterion for optimizing said coupled simulation (4) and distortion (8) models, and a reconstruction residual (32) is calculated from the difference between experimental measurements of primary interest and said result of the simulation model (7),

and **in that** said reconstruction residual (32) is modelled by a residual operator, said residual operator taking, as input, an estimation of the errors (35) made on the parameters of the motion-distorted model and supplying, as output, said reconstruction residual (32), and being a function of the current parameters (9, 34) of the simulation and motion-distorted models.

2. Method according to claim 1, **characterized in that** it implements means making it possible to acquire additional experimental measurements to said measurements of primary interest.

3. Method according to claim 1 or 2, **characterized in that** the optimization (2) of said adjustable parameters (6, 10) of the simulation (4) and distortion (8) models is produced using one of the following cost functions (16):

   - a cost function (16) quantifying the level of distortion of the signal and of the adjustable parameters of said models,
   - a cost function (16) quantifying the deviation between at least a part of the signal originating from the experimental measurements and at least a part of the corresponding signal reconstructed by at least one simulation model (4).

4. Method according to any one of the preceding claims, **characterized in that** the optimization (2) of said adjustable parameters (6, 10) of the simulation (4) and distortion (8) models comprises at least one step of minimizing a reconstruction residual defined as the deviation between at least a part of the signal originating from the experimental measurements and at least a part of the corresponding signal reconstructed by at least one simulation model (4).

5. Method according to any one of the preceding claims, **characterized in that** said simulation model (4) is produced in the form of a linear operator.

6. Method according to any one of the preceding claims, **characterized in that** the solution of said inverse problem of the simulation model (31) is carried out by an iterative method that does not require explicit knowledge of the complete Hermitian operator, such as the conjugate gradient, the Generalized Minimal Residual (GMRES) or the biconjugate gradient.

7. Method according to any one of the preceding claims, **characterized in that** said residual operator comprises linear operators appearing in the simulation operator (17), and a composition of a gradient of the actual signal p (6) and of the additional experimental measurement data.

8. Method according to any one of the preceding claims, **characterized in that**:

   - the optimization of the parameters of the distortion model (8) is produced by the solution of the inverse problem (33) described by said residual operator, said solution of the inverse problem being performed by solving the equivalent Hermitian symmetry problem,
   - said estimation of the errors (35) made on the parameters of the distortion model is used to update the parameters of the distortion model (8).

9. Method according to claim 8, **characterized in that** said solution of the inverse problem (33) described by the residual operator is performed by an iterative method that does not require explicit knowledge of the complete Hermitian operator, such as the conjugate gradient, the Generalized Minimal Residual (GMRES) or the biconjugate gradient, and **in that** it comprises a regularization of one of the following types:

- Tikhonov regularization relating to the parameters of the distortion model (34) added to the errors on the parameters of said distortion model,
- Constraint on the square of the spatial gradient norm of the parameters of the distortion model added to the errors on the parameters of said distortion model.

10. Method according to any one of the preceding claims, **characterized in that** the optimization of said parameters of said simulation (4) and distortion (8) models is produced by a fixed point method,

- each model being optimized separately, all the others being considered fixed, and
- said optimization being produced alternately on each model.

11. Reconstruction method according to claim 10, **characterized in that** said optimization of the parameters of the simulation (4) and distortion (8) models is repeated according to a primary iteration (57),

- the optimal parameters being those giving the smallest residual (32), and
- said primary iteration (57) being governed by a stop condition (58), which is established by any one of the following criteria: the difference between said residuals (32) during two separate incrementations of the primary iteration (57), a predetermined minimum value of said residual (32), or a predetermined number of iterations.

12. Method according to any one of claims 10 or 11, **characterized in that** said optimization of the parameters of the simulation (4) and distortion (8) models is repeated according to a secondary multi-resolution iteration (59) established on the basis of a level of resolution of the first signal (3).

13. Method according to any one of claims 2 to 12, **characterized in that** the simulation model (4) is produced in the form of a linear operator (17) comprising:

- a spatial transformation operator (19), modelled by said distortion model (8), by the motion,
- an antenna sensitivity weighting operator (20),
- a coding operator (21), and
- a sampling operator (22) on a Cartesian grid.

14. Method according to claim 13, **characterized in that** said spatial transformation operator (19) is an elastic spatial transformation operator making it possible to take into account locally free deformations.

15. Method according to claim 13 or 14, **characterized in that** said spatial transformation operator (19) is modelled by at least one motion-distorted model,

- said motion distorting the experimental measurements of primary interest,
- said motion-distorted model being able to be decomposed into a set of parameters describing the spatial dependence of the model, and at least one item of information correlated to the motion at different acquisition times of the experimental measurements,
- said distortion model by the motion being linear, modelling the temporal evolution of the parameters describing the motion by linear combinations of signals originating from said additional experimental measurements.

16. Method according to claim 15, **characterized in that** said additional experimental measurements are used to constrain the motion-distorted model.

17. Method according to any one of claims 13 to 16, **characterized in that** said antenna sensitivity weighting operator (20) is modelled by at least one sensitivity distortion model, said sensitivity distortion model being able to be decomposed into a set of parameters describing at least one antenna sensitivity map, and **in that** the residual operator (39) is written in the same way as the simulation operator (17), replacing said antenna sensitivity weighting operator (20) with a diagonal operator, the diagonal of which is constituted by the resultant of the composition of the current signal (6) by a spatial transformation operator (19).

**18.** Method according to any one of claims 13 to 17, **characterized in that** said coding operator (21) is an operator of the Fourier transform type.

**19.** Method according to any one of claims 2 to 18, **characterized in that** it comprises a step of acquiring data and preparing the reconstruction (25), said step comprising:

- said at least one acquisition of experimental measurements of primary interest (1),
- and an acquisition of additional experimental measurements (26), said additional experimental measurements originating at least from one of: an external sensor, an echonavigator and experimental measurements of primary interest,
- the synchronization of the events relating to the acquisition of the experimental measurements of primary interest and the acquisition of the additional experimental measurements, such as the acquisition times and the order of acquisition of the data.

**20.** Method according to claim 19, **characterized in that** the preparation of the reconstruction (25) comprises an operation of sorting the experimental measurements of primary interest to which similar constraints are applied,

- said similar constraints are based on items of similar additional experimental measurement data,
- said sorting operation producing at least one item of sorted additional experimental data and at least one set of indices of interest describing said sorting of the experimental measurement data of primary interest,
- said experimental measurements of primary interest being grouped together in at least one set corresponding to said set of indices of interest.

**21.** Method according to claim 20, **characterized in that** at least one set of indices of interest is determined by carrying out a quantification of the variation space of the additional experimental measurement data.

**22.** Method according to any one of claims 19 to 21, **characterized in that** said preparation of the reconstruction (25) comprises at least one pre-transformation of the experimental measurements of primary interest, such as a Fourier transform in the direction or directions independent of the distortion caused by the motion.

**23.** Method according to any one of claims 20 to 22, **characterized in that** the operator of the simulation model (4) is decomposed into at least one sub-element indexed by said indices of interest,

- said experimental acquisitions of primary interest, grouped together in indexed sets, being the distorted experimental data to be reconstructed (13),
- said data originating from the additional experimental measurements sorted according to said indices of interest being the additional experimental data (12) used to constrain said distortion model by the motion.

**24.** Method according to any one of claims 2 to 23, **characterized in that** it comprises adjustable acquisition parameters (46),

- said adjustable acquisition parameters being taken into account by the simulation and distortion models,
- said adjustable acquisition parameters being a function of the parameters of the optimized distortion models,
- said adjustable acquisition parameters being updated after the optimal parameters of said simulation and distortion models have been established (55),
- said updating of said adjustable acquisition parameters being repeated according to an iteration governed by a stop condition.

**25.** Method according to claim 24, **characterized in that**

- said adjustable acquisition parameters are affine transformation parameters of an MRI acquisition volume,
- said updating of said adjustable acquisition parameters is an affine transformation model of an MRI acquisition volume dependent in real time on the additional experimental measurements.

**26.** Method according to any one of claims 1 to 23, **characterized in that** said experimental measurements originate from an NMR procedure and said first signal (3) is reconstructed in the form of at least one spectrum of at least one NMR spectroscopy voxel.

27. Method according to any one of claims 1 to 17 and 19 to 24, **characterized in that** said first signal (3) is reconstructed in a form chosen from a voxel, an image, an image stack and a volume and said experimental measurements originate from a medical image acquisition procedure chosen from X-ray tomography, positron emission tomography, single-photon emission tomography and echography.

Figure 1

Figure 2

17

$E$

6

| Données d'entrée (image) $\rho$ |
|---|

18

| Simulation d'acquisition $t_1$ $\cdots, T_{t_1}, \cdots, \sigma_{\gamma, t_1}, \cdots, F_{t_1}, \cdots, \xi_{t_1}, \cdots$ |
|---|

19  20  21  22

23

| Simulation d'acquisition $t_2$ $\cdots, T_{t_2}, \cdots, \sigma_{\gamma, t_2}, \cdots, F_{t_2}, \cdots, \xi_{t_2}, \cdots$ |
|---|

24

| Simulation d'acquisition $t_N$ $\cdots, T_{t_N}, \cdots, \sigma_{\gamma, t_N}, \cdots, F_{t_N}, \cdots, \xi_{t_N}, \cdots$ |
|---|

7

| Simulation en sortie (espaces k) $s_\gamma$ |
|---|

Figure 3

Figure 4

Figure 5

Figure 6

Figure 7

## RÉFÉRENCES CITÉES DANS LA DESCRIPTION

**Documents brevets cités dans la description**

- US 6341179 B
- US 7030609 B
- US 20070182411 A1, de Bammer
- US 4701706 A, de Haacke

**Littérature non-brevet citée dans la description**

- **BATCHELOR et al.** Matrix description of general motion correction applied to multishot images. *Magn Reson Med,* 2005, vol. 54 (5), 1273-1280
- **PRUESSMANN et al.** *Advances in Sensitivity Encoding With Arbitrary k-Space Trajectories,* 2001
- **BAMMER et al.** Augmented Generalized SENSE Reconstruction to Correct for Rigid Body Motion. *Magn. Reson. Med.,* 2007, vol. 57 (1), 90-102
- **DE HESS et al.** Maximum Cross-Entropy Generalized Series reconstruction. *international Journal of Imaging System and Technology,* 1999, vol. 10, 258-265
- **DE DEMING et al.** Computerized Tomographic Imaging of Time-varying Objects using Mixture models. *IEEE conférence CIMSA 2005,* 2005, 322-327
- **DE KNUTSSON H et al.** Motion artifact réduction in MRI through generalized DFT. *IEEE International Symposium on Biomedical Imaging: Macro to Nano,* 2004, 896-899